# DEMANDE DE BREVET EUROPEEN

(11) **EP 4 417 456 A1**
(43) Date de publication de la demande: **21.08.2024**
(21) Numéro de dépôt: 24157378.1
(22) Date de dépôt: 13.02.2024
(51) Int. Cl.: B60L 3/00, B60L 3/12, B60L 3/04, B60L 53/10, B60L 53/14, B60L 53/16, B60L 53/30, B60L 53/67, B60L 53/62, B60L 53/66, B60L 55/00, G01R 27/16, G01R 27/18, G01R 31/52, H02J 7/00, H02J 7/02, H01M 10/44, H01M 10/625, H02M 1/00, H02M 1/32

(54) **MÉTHODE DE DIAGNOSTIC D'UN SYSTÈME DE STATION DE RECHARGE POUR VÉHICULE ÉLECTRIQUE ET SYSTÈME DE STATION DE RECHARGE POUR VÉHICULE ÉLECTRIQUE**

(30) Priorité: 14.02.2023 FR 2301353; 28.03.2023 FR 2302950
(71) Demandeur: SCHNEIDER ELECTRIC INDUSTRIES SAS, 92500 Rueil-Malmaison (FR)
(72) Inventeur: DE CESARIS, Stefano, 38100 GRENOBLE (FR)
(74) Mandataire: Lavoix

(57) **Abrégé**

Ce système de station de recharge (10) comprend deux prises (52,62), chacune configurée pour permettre la recharge d'un véhicule électrique en lui fournissant un courant continu, deux conducteurs (40,46), associés chacun à une prise (52,92), et deux groupes de modules de puissance (18), associés chacun à une prise (52,62) et aptes à transformer un courant provenant d'un réseau électrique en courant continu délivré à la prise associée (52,62). La méthode de diagnostic comprend une étape de connexion, visant à connecter ensemble les deux prises (52,62) de manière à former une boucle comprenant les deux prises (52,62), les deux conducteurs et les deux groupes de modules de puissance (18); une étape de test, consistant à émettre une grandeur électrique circulant entre les deux prises (52,62), dans la boucle, et à mesurer des états de fonctionnement d'une partie au moins des éléments de la boucle en réaction à cette grandeur électrique ; et une étape d'analyse consistant à diagnostiquer lesdits éléments sur la base des mesures des états de fonctionnement.

## Description

La présente invention concerne une méthode de diagnostic d'un système de station de recharge pour véhicule électrique et un système de station de recharge pour véhicule électrique mettant en oeuvre une telle méthode de diagnostic.

Il est connu d'utiliser une station de recharge pour recharger la batterie d'un véhicule électrique, comme par exemple d'une voiture électrique ou d'un camion électrique.

Généralement, une telle station de recharge comprend les composants suivants :
- un ou plusieurs modules de puissance, qui convertissent un courant alternatif ou continu provenant d'un réseau électrique en courant continu, et qui sont généralement en mesure de fournir une puissance pouvant aller jusqu'à plusieurs dizaines de kilowatt,
- une prise, reliée aux modules de puissance par un conducteur, qui permet d'établir une connexion entre les modules de puissance et un véhicule électrique, de sorte à fournir le courant continu produit par les modules de puissance au véhicule électrique, et
- une unité de contrôle, qui contrôle le fonctionnement de la prise.

En outre, une station de recharge dispose généralement de moyens de communication, contrôlés par l'unité de contrôle, qui permettent un échange de données de fonctionnement entre la station de recharge et un véhicule électrique connecté à la prise, de sorte à superviser la recharge du véhicule électrique.

Il est nécessaire de vérifier régulièrement le bon fonctionnement d'une telle station de recharge, pour s'assurer du bon fonctionnement des modules de puissance et/ou d'organes de contrôles de la station de recharge, et également pour s'assurer de l'intégrité du conducteur et de la prise. En effet, le conducteur et la prise sont des pièces d'usure exposées à de nombreuses contraintes pouvant entraîner leur dégradation, tel que par exemple une rupture d'isolation ou une panne des moyens de communication.

Deux méthodes différentes sont connues pour diagnostiquer le bon fonctionnement d'une station de recharge.

Une première méthode consiste à brancher à la station de recharge un véhicule électrique de test dont la batterie a été préalablement vidée, et de surveiller à l'aide de divers capteurs la recharge du véhicule électrique. Cette méthode présente l'inconvénient de nécessiter la mise à disposition d'un véhicule électrique dont la batterie a été préalablement vidée, ce qui est logistiquement complexe et coûteux.

Une deuxième méthode consiste à brancher à la station de recharge une charge électrique en mesure de consommer le courant produit par les modules de puissance, de sorte à simuler le fonctionnement d'un véhicule électrique. Une telle charge électrique est généralement encombrante, lourde et onéreuse, ce qui rend son déplacement difficile et ce qui rend cette deuxième méthode également complexe et coûteuse.

C'est à ces inconvénients qu'entend plus particulièrement remédier l'invention en proposant une méthode de diagnostic d'un système de station de recharge pour véhicule électrique ne nécessitant pas d'équipement complexe pour sa mise en oeuvre, et qui est simple et peu onéreuse à exécuter.

À cet effet, l'invention concerne une méthode de diagnostic d'un système de station de recharge pour véhicule électrique, le système de station de recharge comprenant au moins :
- au moins une première prise et une deuxième prise, chaque prise comportant un point de connexion positif et un point de connexion négatif, chaque prise étant configurée pour permettre la connexion électrique d'un véhicule électrique au système de station de recharge et pour permettre la fourniture d'un courant continu au véhicule électrique de manière à recharger le véhicule électrique,
- au moins un premier conducteur, associé à la première prise, et un deuxième conducteur, associé à la deuxième prise, chaque conducteur comprenant un câble à polarité positive et un câble à polarité négative, et
- au moins un premier groupe de modules de puissance associé au premier conducteur et à la première prise et un deuxième groupe de modules de puissance associé au deuxième conducteur et à la deuxième prise, chaque groupe de modules de puissance étant apte à transformer un courant alternatif ou un courant continu provenant d'un réseau électrique en un courant continu délivré à la prise associée par l'intermédiaire du conducteur associé.
Selon l'invention, la méthode de diagnostic comprend au moins les étapes suivantes :
- une étape de connexion, consistant à connecter le point de connexion positif de la première prise avec le point de connexion positif de la deuxième prise et à connecter le point de connexion négatif de la première prise avec le point de connexion négatif de la deuxième prise, de manière à former une boucle comprenant au moins :
   ∘ les première et deuxième prises,
   ∘ les premier et deuxième conducteurs, et
   ∘ les premier et deuxième groupes de modules de puissance,
- une étape de test, consistant à émettre au moins une grandeur électrique circulant au moins de la première prise vers la deuxième prise et à mesurer des états de fonctionnement d'une partie au moins des éléments de la boucle en réaction à la grandeur électrique émise, et
- une étape d'analyse, consistant à réaliser un diagnostic desdits éléments sur la base des mesures des états de fonctionnement.

Grâce à l'invention, il est possible de diagnostiquer un système de station de recharge comprenant une station de recharge présentant deux prises, ou bien comprenant deux stations de recharge présentant chacune une prise, simplement en branchant les deux prises l'une à l'autre. Ainsi, une partie du système de station de recharge simule un véhicule électrique pendant que l'autre partie du système de station de recharge se comporte comme s'il rechargeait un véhicule électrique, permettant de diagnostiquer le système de station de recharge sans nécessiter l'utilisation d'une charge électrique externe ni d'un véhicule électrique.

Selon des aspects avantageux, mais non-obligatoires de l'invention, cette méthode de diagnostic d'un système de station de recharge pour véhicule électrique incorpore une ou plusieurs des caractéristiques suivantes, prises isolément ou selon toutes combinaisons techniquement admissibles :
- Le système de station de recharge comprend en outre :
   - un premier dispositif de contrôle d'isolation, connecté au câble à polarité positive et au câble à polarité négative du premier conducteur, ainsi qu'à une prise de terre, et apte à effectuer un calcul d'impédance entre :
      ∘ ledit câble à polarité positive et ladite prise de terre,
      ∘ ledit câble à polarité négative et ladite prise de terre, et/ou
      ∘ ledit câble à polarité positive et ledit câble à polarité négative, et
   - un deuxième dispositif de contrôle d'isolation, connecté au câble à polarité positive et au câble à polarité négative du deuxième conducteur, ainsi qu'à une prise de terre, et apte à effectuer un calcul d'impédance entre :
      ∘ ledit câble à polarité positive et ladite prise de terre,
      ∘ ledit câble à polarité négative et ladite prise de terre, et/ou
      ∘ ledit câble à polarité positive et ledit câble à polarité négative,

   le système de station de recharge comprend en outre des organes d'isolement qui sont soit disposés dans le deuxième groupe de modules de puissance, soit disposés dans le deuxième conducteur entre le deuxième groupe de modules de puissance et le deuxième dispositif de contrôle d'isolation,
   les organes d'isolement sont opérables entre une position ouverte dans laquelle la circulation d'une tension et d'un courant entre le deuxième groupe de modules de puissance et le deuxième dispositif de contrôle d'isolation est empêchée, et une position fermée dans laquelle la circulation d'une tension et d'un courant entre le deuxième groupe de modules de puissance et le deuxième dispositif de contrôle d'isolation n'est pas empêchée,
   l'étape de test comprend en outre une phase d'ouverture consistant à maintenir les organes d'isolement en position ouverte,
   l'au moins une grandeur électrique émise au cours de l'étape de test comprend un signal de test, émis pendant la phase d'ouverture par le premier dispositif de contrôle d'isolation dans le premier conducteur et circulant dans la boucle jusqu'aux organes d'isolement, par l'intermédiaire de la première prise et de la deuxième prise,
   au cours de l'étape d'analyse, un diagnostic de l'intégrité de l'isolation des premier et deuxième conducteurs et de la fiabilité des premier et deuxième dispositifs de contrôle d'isolation est réalisé en comparant entre elles :
      - une valeur d'impédance entre le câble à polarité positive du premier conducteur et la prise de terre du premier dispositif de contrôle d'isolation avec une valeur d'impédance entre le câble à polarité positive du deuxième conducteur et la prise de terre du deuxième dispositif de contrôle d'isolation, les valeurs d'impédance étant calculées pendant la phase d'ouverture par les premier et deuxième dispositifs de contrôle d'isolation sur la base du signal de test,
      - et/ou une valeur d'impédance entre le câble à polarité négative du premier conducteur et la prise de terre du premier dispositif de contrôle d'isolation avec une valeur d'impédance entre le câble à polarité négative du deuxième conducteur et la prise de terre du deuxième dispositif de contrôle d'isolation, les valeurs d'impédance étant calculées pendant la phase d'ouverture par les premier et deuxième dispositifs de contrôle d'isolation sur la base du signal de test,
      - et/ou une valeur d'impédance entre les câbles à polarité positive et négative du premier conducteur avec une valeur d'impédance entre les câbles à polarité positive et négative du deuxième conducteur, les valeurs d'impédance étant calculées pendant la phase d'ouverture par les premier et deuxième dispositifs de contrôle d'isolation sur la base du signal de test.
- Le système de station de recharge comporte un voltmètre amont, adapté pour mesurer une tension aux bornes de sortie du deuxième groupe de modules de puissance,
   le système de station de recharge comprend en outre des organes d'isolement qui sont soit disposés dans le deuxième groupe de modules de puissance, soit disposés dans le deuxième conducteur entre le deuxième groupe de modules de puissance et la deuxième prise,
   les organes d'isolement sont opérables entre une position ouverte dans laquelle la circulation d'une tension et d'un courant entre le deuxième groupe de modules de puissance et la deuxième prise est empêchée, et une position fermée dans laquelle la circulation d'une tension et d'un courant entre le deuxième groupe de modules de puissance et la deuxième prise n'est pas empêchée,
   l'étape de test comprend en outre une phase d'ouverture consistant à maintenir les organes d'isolement en position ouverte,
   l'au moins une grandeur électrique émise au cours de l'étape de test comprend une tension continue, émise pendant la phase d'ouverture par le premier groupe de modules de puissance et circulant dans la boucle jusqu'aux organes d'isolement, par l'intermédiaire de la première prise et de la deuxième prise,
   l'étape de test comprend, pendant la phase d'ouverture, une mesure de tension réalisée par le voltmètre amont,
   et l'étape d'analyse comprend en outre un diagnostic de fonctionnement des organes d'isolement, réalisé en vérifiant si la tension mesurée par le voltmètre amont pendant la phase d'ouverture est nulle.
- Le deuxième conducteur comprend en outre un voltmètre aval, disposé entre les organes d'isolement et la deuxième prise, adapté pour mesurer une tension entre le câble à polarité positive et le câble à polarité négative du deuxième conducteur,
   l'étape de test comprend en outre une phase de fermeture consistant à maintenir les organes d'isolement en position fermée,
   l'au moins une grandeur électrique émise au cours de l'étape de test comprend en outre une tension continue, émise pendant la phase de fermeture par le premier groupe de modules de puissance et circulant dans la boucle jusqu'au deuxième groupe de modules de puissance, par l'intermédiaire de la première prise et de la deuxième prise,
   et, au cours de l'étape d'analyse, un diagnostic de l'intégrité des organes d'isolement du deuxième conducteur est réalisé en comparant une tension mesurée par le voltmètre amont pendant la phase de fermeture avec une tension mesurée par le voltmètre aval pendant la phase de fermeture.
- Le système de station de recharge comprend en outre au moins une première unité de contrôle associée à la première prise et une deuxième unité de contrôle associée à la deuxième prise, chaque unité de contrôle contrôlant le fonctionnement de la prise associée, la première prise et la deuxième prise comportent en outre chacune des moyens de communication connectés à l'unité de contrôle associée, et configurés pour, lorsqu'une prise est connectée électriquement à un véhicule électrique, permettre la communication entre un véhicule électrique et l'unité de contrôle associée à ladite prise,
   au cours de l'étape de connexion, les moyens de communication de la première prise sont connectés avec les moyens de communication de la deuxième prise,
   l'au moins une grandeur électrique émise au cours de l'étape de test comprend un signal de communication, émis par la première unité de contrôle et circulant jusqu'à la deuxième unité de contrôle par l'intermédiaire de la première prise et de la deuxième prise,
   et, au cours de l'étape d'analyse, un diagnostic de l'intégrité des moyens de communication des première et deuxième prises et de la deuxième unité de contrôle est réalisé de la manière suivante :
      - en comparant le signal de communication émis par la première unité de contrôle avec le signal de communication reçu par la deuxième unité de contrôle,
      - et/ou en analysant un signal de réponse émis par la deuxième unité de contrôle en réaction à la réception du signal de communication.
- Les premier et deuxième groupes de modules de puissance sont en outre aptes à transformer un courant continu provenant de la prise associée en un courant alternatif ou en un courant continu adapté pour être délivré au réseau électrique,
   et l'au moins une grandeur électrique émise au cours de l'étape de test comprend un courant continu, émis par le premier groupe de modules de puissance et circulant dans la boucle jusqu'au deuxième groupe de modules de puissance, par l'intermédiaire de la première prise et de la deuxième prise, le courant continu reçu par le deuxième groupe de modules de puissance étant transformé en courant alternatif ou en courant continu apte à être délivré au réseau électrique.
- Le système de station de recharge comprend en outre un commutateur de puissance d'entrée et un système de distribution, le commutateur de puissance d'entrée étant configuré pour permettre la connexion du système de distribution au réseau électrique, et le système de distribution étant configuré pour connecter les premier et deuxième groupes de modules de puissance entre eux et au commutateur de puissance d'entrée, le deuxième groupe de modules de puissance étant en outre apte à transformer un courant continu provenant du système de station de recharge en un courant alternatif ou en un courant continu délivré au premier groupe de modules de puissance,
   au cours de l'étape de test, le courant continu reçu par le deuxième groupe de modules de puissance est transformé par le deuxième groupe de modules de puissance en courant alternatif ou en courant continu délivré au premier groupe de modules de puissance par l'intermédiaire du système de distribution,
   au cours de l'étape de test, le premier groupe de modules de puissance est alimenté en courant alternatif ou en courant continu par le deuxième groupe de modules de puissance et par le réseau électrique,
   et au moins 90% de la puissance électrique consommée par le premier groupe de modules de puissance au cours de l'étape de test est délivrée au premier groupe de modules de puissance par le deuxième groupe de modules de puissance.
- Le système de station de recharge comprend en outre :
   - un premier compteur d'électricité, disposé entre le premier groupe de modules de puissance et la première prise et adapté pour mesurer une tension et une intensité du courant continu circulant dans le premier conducteur,
   - un deuxième compteur d'électricité, disposé entre le deuxième groupe de modules de puissance et la deuxième prise et adapté pour mesurer une tension et une intensité du courant continu circulant dans le deuxième conducteur,
   et l'étape d'analyse comprend un diagnostic de fiabilité des compteurs d'électricité, réalisé en comparant des mesures de tension et d'intensité effectuées par le premier compteur d'électricité pendant l'étape de test avec des mesures de tension et d'intensité effectuées par le deuxième compteur d'électricité pendant l'étape de test.
- Le système de station de recharge comprend en outre :
   - un premier capteur de température, disposé au niveau de la première prise ou au niveau du premier conducteur, et/ou
   - un deuxième capteur de température, disposé au niveau de la deuxième prise ou au niveau du deuxième conducteur,
   et l'étape d'analyse comprend un diagnostic de surchauffe, réalisé en analysant des mesures de température effectuées par le premier capteur de température et/ou par le deuxième capteur de température pendant l'étape de test.
- Au cours de l'étape de test, une puissance électrique fournie par le premier groupe de modules de puissance au deuxième groupe de modules de puissance par l'intermédiaire du courant continu émis par le premier groupe de modules de puissance est supérieure d'au moins 5 % à une puissance électrique nominale du deuxième groupe de modules de puissance,
   et l'étape d'analyse comprend un diagnostic de résistance à la surcharge du deuxième groupe de modules de puissance, réalisé en analysant des grandeurs caractéristiques du fonctionnement du deuxième groupe de modules de puissance mesurées pendant l'étape de test.

Selon un autre aspect, l'invention concerne également un système de station de recharge pour véhicule électrique comprenant au moins :
- au moins une première prise et une deuxième prise, chaque prise comportant un point de connexion positif et un point de connexion négatif, chaque prise étant configurée pour permettre la connexion électrique d'un véhicule électrique au système de station de recharge et pour permettre la fourniture d'un courant continu au véhicule électrique de manière à recharger le véhicule électrique,
- au moins un premier conducteur, associé à la première prise, et un deuxième conducteur, associé à la deuxième prise, chaque conducteur comprenant un câble à polarité positive et un câble à polarité négative, et
- au moins un premier groupe de modules de puissance associé au premier conducteur et à la première prise et un deuxième groupe de modules de puissance associé au deuxième conducteur et à la deuxième prise, chaque groupe de modules de puissance étant apte à transformer un courant alternatif ou un courant continu provenant d'un réseau électrique en un courant continu délivré à la prise associée par l'intermédiaire du conducteur associé.
Selon l'invention, le système de station de recharge comprend en outre des moyens de connexion adaptés pour connecter le point de connexion positif de la première prise avec le point de connexion positif de la deuxième prise et pour connecter le point de connexion négatif de la première prise avec le point de connexion négatif de la deuxième prise,
et le système de station de recharge comprend un module de commande configuré pour exécuter les étapes de test et d'analyse de la méthode de diagnostic décrite ci-dessus.

Ce système de station de recharge induit les mêmes avantages que ceux mentionnés ci-dessus au sujet de la méthode de diagnostic de l'invention.

Selon des aspects avantageux, mais non-obligatoires de l'invention, ce système de station de recharge incorpore une ou plusieurs des caractéristiques suivantes, prises isolément ou selon toutes combinaisons techniquement admissibles :
- Le module de commande est physiquement connecté à la première prise et/ou à la deuxième prise, ou alors le module de commande est intégré à un serveur distant.
- Les moyens de connexion sont formés par un outil de connexion, tel qu'un câble ou un boîtier, présentant un premier embout femelle adapté pour être connecté à la première prise et présentant un deuxième embout femelle adapté pour être connecté à la deuxième prise.
- Le système de station de recharge comprend une unique station de recharge comportant :
   - au moins deux modules de puissance, chaque module de puissance étant apte à transformer un courant alternatif ou un courant continu provenant du réseau électrique en un courant continu délivré au système de station de recharge,
   - au moins une unité de distribution de puissance :
      ∘ comprenant au moins une première borne de sortie connectée au premier conducteur et une deuxième borne de sortie connectée au deuxième conducteur,
      ∘ une sortie de chacun des modules de puissance étant électriquement couplée à l'unité de distribution de puissance,
      ∘ l'unité de distribution étant configurée pour être commutable de sorte que chaque module de puissance est soit connecté à la première borne de sortie, soit connecté à la deuxième borne de sortie, ou soit isolé des première et deuxième borne de sortie ;

   le ou les modules de puissance connectés à la première borne de sortie forment le premier groupe de modules de puissance,
   et le ou les modules de puissance connectés à la deuxième borne de sortie forment le deuxième groupe de modules de puissance.
- Le système de station de recharge comprend :
   - une première station de recharge comportant la première prise, le premier conducteur et le premier groupe de modules de puissance, et
   - une deuxième station de recharge distincte de la première station de recharge comportant la deuxième prise, le deuxième conducteur et le deuxième groupe de modules de puissance.

L'invention sera mieux comprise et d'autres avantages de celle-ci apparaitront plus clairement à la lumière de la description qui va suivre d'un mode de réalisation d'une méthode de diagnostic d'un système de station de recharge pour véhicule électrique et d'un système de station de recharge pour véhicule électrique, donnée uniquement à titre d'exemple et faite en référence aux dessins annexés dans lesquels :
[Fig. 1] La figure 1 est un schéma de fonctionnement d'un système de station de recharge pour véhicule électrique conforme à l'invention.
[Fig. 2] La figure 2 est une vue à plus grande échelle du détail II de la figure 1.
[Fig. 3] La figure 3 est une vue à plus grande échelle du détail III de la figure 1.

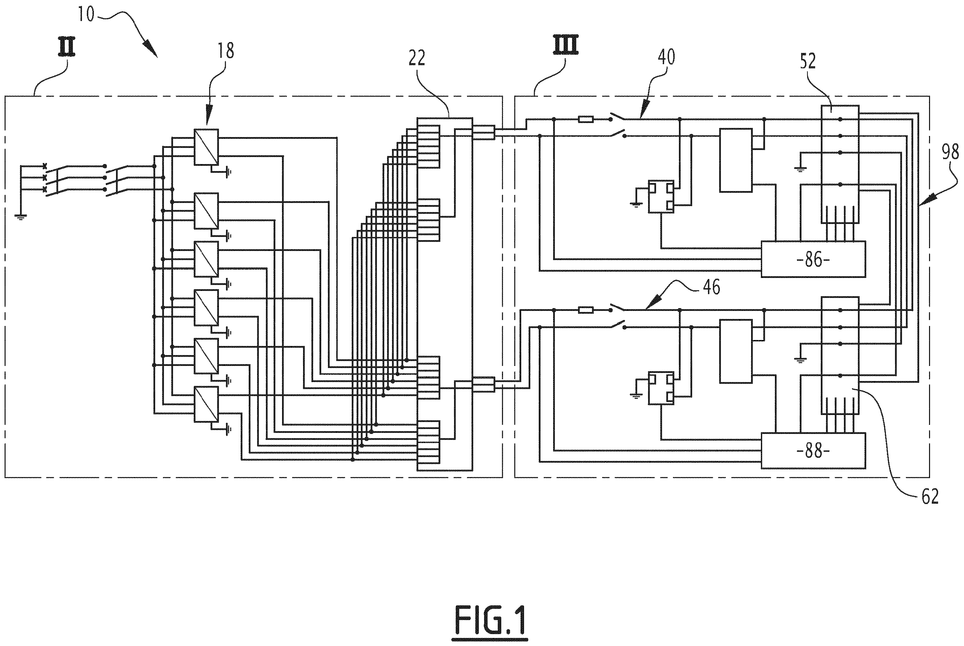

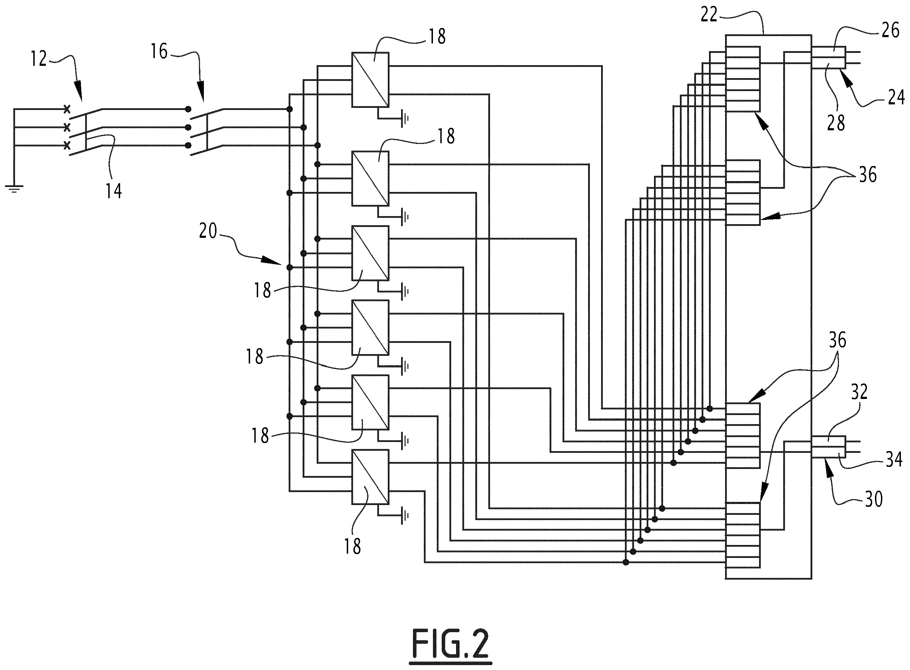

Un système de station de recharge 10 est schématiquement représenté aux figures 1 à 3.

Le système de station de recharge 10 comprend un bornier d'entrée 12, raccordé à un réseau électrique alternatif alimentant le système de station de recharge. Ici le réseau électrique alternatif est triphasé, donc le bornier d'entrée 12 présente trois phases. Le bornier d'entrée 12 comporte un disjoncteur triphasé 14, en mesure de couper les trois phases et protégeant ces trois phases d'éventuels défauts électriques.

Le système de station de recharge 10 comprend un commutateur de puissance d'entrée 16, permettant de déconnecter le système de station de recharge 10 du réseau électrique en déconnectant chacune des phases.

Le système de station de recharge 10 comprend six modules de puissance 18 ainsi qu'un système de distribution 20, qui est par exemple un jeu de barres conductrice ou un ensemble de câbles électriques, et qui relie chacun des modules le puissance 18 entre eux et au commutateur de puissance d'entrée 16. Ainsi, les modules de puissance 18 sont tous raccordés au réseau électrique, et donc tous alimentés en courant alternatif, par l'intermédiaire du système de distribution 20 et du commutateur de puissance d'entrée 16. De préférence, par mesure de sécurité, chaque module de puissance 18 est raccordé à une prise de terre.

Le système de station de recharge 10 comprend une unité de distribution de puissance 22, à laquelle les modules de puissance 18 sont raccordés.

Chaque module de puissance 18 est apte à transformer le courant alternatif provenant du réseau électrique en un courant continu délivré à l'unité de distribution de puissance 22. En d'autres termes, chaque module de puissance 18 peut fonctionner comme un convertisseur alternatif/continu, c'est-à-dire comme un redresseur.

Dans la suite de la description, on désigne « bornes d'entrée » les bornes des modules de puissance 18 raccordées au réseau électrique, et « bornes de sortie » les bornes des modules de puissance raccordées à l'unité de distribution de puissance 22.

En outre, chaque module de puissance 18 embarque un ampèremètre et un voltmètre, formant ensemble un compteur d'électricité, permettant de mesurer la tension et l'intensité du courant continu délivré par le module de puissance à l'unité de distribution de puissance 22, c'est-à-dire aux bornes de sortie du module de puissance. Autrement dit, la puissance électrique du courant continu délivré par chaque module de puissance 18 est mesurée par le compteur d'électricité. De préférence, chaque module de puissance 18 est en mesure de fournir à l'unité de distribution de puissance 22 une puissance électrique comprise entre 10 et 100 kilowatt (kW), par exemple 30 kilowatt. Dans la suite de la description, on désigne par l'expression « puissante nominale » la puissance électrique maximale à laquelle un module de puissance 18 est prévu pour fonctionner en conditions normales de fonctionnement. Ainsi, la puissance nominale d'un module de puissance 18 correspond à la puissance maximale que ce module de puissance peut délivrer en sécurité à l'unité de distribution de puissance 22.

De préférence, tous les modules de puissance 18 sont identiques et ont donc la même puissance nominale.

De plus, chaque module de puissance 18 est commandable de sorte à ajuster la puissance délivrée à l'unité de distribution de puissance 22. Ainsi, chaque module de puissance est en mesure de fournir entre 0% et 100% de sa puissance nominale à l'unité de distribution de puissance.

Avantageusement, chaque module de puissance 18 est également apte à transformer un courant continu provenant de l'unité de distribution de puissance 22 en un courant alternatif injecté dans le réseau électrique, c'est-à-dire que chaque module de puissance 18 peut fonctionner comme un onduleur. Autrement dit, les modules de puissance 18 sont réversibles. De préférence, en conditions normales de fonctionnement, chaque module de puissance est prévu pour être en mesure de fournir au réseau électrique une puissance électrique maximale égale à la puissance nominale du module de puissance.

L'unité de distribution de puissance 22 comprend une première borne de sortie 24, comportant une sortie à polarité positive 26 et une sortie à polarité négative 28, et une deuxième borne de sortie 30, comportant une sortie à polarité positive 32 et une sortie à polarité négative 34.

Chaque module de puissance 18 comprend une sortie négative et une sortie positive.

Par l'intermédiaire de quatre groupes de relais 36 de l'unité de distribution de puissance 22, les sorties à polarité positive 26, 32 des bornes de sortie 24, 30 sont connectées aux sorties positives de tous les modules de puissance 18, et les sorties à polarité négative 28, 34 des bornes de sortie 24, 30 sont connectées aux sorties négatives de tous les modules de puissance. Chaque groupe de relais 36 comprend autant de relais que le système de station de recharge comprend de modules de puissance 18.

Plus précisément, un premier groupe de relais relie la sortie positive de chacun des modules de puissance 18 à la sortie à polarité positive 26 de la première borne de sortie 24, un deuxième groupe de relais relie la sortie positive de chacun des modules de puissance 18 à la sortie à polarité positive 32 de la deuxième borne de sortie 30, un troisième groupe de relais relie la sortie négative de chacun des modules de puissance 18 à la sortie à polarité négative 28 de la première borne de sortie 24 et un quatrième groupe de relais relie la sortie négative de chacun des modules de puissance 18 à la sortie à polarité négative 34 de la deuxième borne de sortie 30.

En pratique, les sorties positive et négative de chaque module de puissance 18 sont connectées aux groupes de relais 36 de l'unité de distribution de puissance 22 soit par des câbles électriques, soit par des jeux de barres.

Ainsi, les deux bornes de sortie 24, 30 sont connectées à tous les modules de puissance 18. De plus, les relais des groupes de relais 36 sont commutables de sorte que chaque module de puissance 18 est soit connecté à la première borne de sortie 24, soit connecté à la deuxième borne de sortie 30, soit isolé des premières et deuxième bornes de sortie. Autrement dit, les groupes de relais 36 sont commutés de sorte qu'un module de puissance 18 ne peut pas être simultanément connecté aux deux bornes de sortie 24, 30, ou encore de sorte que le câble à polarité positive et le câble à polarité négative d'un module de puissance ne peuvent pas être connectés à deux bornes de sortie différentes de l'unité de distribution de puissance.

On distingue alors un premier groupe de modules de puissance, qui comprend les modules de puissance 18 connectés à la première borne de sortie 24, un deuxième groupe de modules de puissance, qui comprend les modules de puissance 18 connectés à la deuxième borne de sortie 30, et un troisième groupe de modules de puissance, qui comprend les modules de puissance 18 n'étant connecté à aucune borne de sortie. Les modules de puissance 18 d'un même groupe de modules de puissance sont montés en parallèle, de sorte que la tension délivrée par un groupe de modules de puissance ne varie pas avec le nombre de modules de puissance appartenant à ce groupe, et de sorte que le courant délivré par un groupe de modules de puissance correspond à la somme du courant délivré par tous les modules de puissance de ce groupe.

En pratique, on peut assimiler le premier groupe de modules de puissance à un unique module de puissance dont la puissance nominale est égale à la somme des puissances nominales des modules de puissance appartenant au premier groupe. Il en est de même pour le deuxième groupe de modules de puissance. Ainsi, mesurer la tension aux bornes de sortie d'un module de puissance est équivalent à mesurer la tension aux bornes de sortie du groupe de modules de puissance auquel appartient ce module.

Le système de station de recharge 10 comprend un premier conducteur 40, qui comporte un câble à polarité positive 42 connecté à la sortie à polarité positive 26 de la première borne de sortie 24, et un câble à polarité négative 44 connecté à la sortie à polarité négative 28 de la première borne de sortie 24, ainsi qu'un deuxième conducteur 46, qui comporte un câble à polarité positive 48 connecté à la sortie à polarité positive 32 de la deuxième borne de sortie 30, et un câble à polarité négative 50 connecté à la sortie à polarité négative 34 de la deuxième borne de sortie 30.

Le système de station de recharge 10 comprend une première prise 52, qui comporte un point de connexion positif 54 et un point de connexion négatif 56, connectés respectivement au câble à polarité positive 42 et négative 44 du premier conducteur 40, ainsi qu'un point de connexion de terre 58, connecté à une prise de terre.

Le système de station de recharge 10 comprend une deuxième prise 62, qui comporte un point de connexion positif 64 et un point de connexion négatif 66, connectés respectivement au câble à polarité positive 48 et négative 50 du deuxième conducteur 46, ainsi qu'un point de connexion de terre 68, connecté à une prise de terre.

Ainsi, la première prise 52 et la deuxième prise 62 sont respectivement connectées à la première borne de sortie 24 et à la deuxième borne de sortie 30 de l'unité de distribution de puissance 22.

Chacune des première et deuxième prises 52, 62 est adaptée à être branchée à un véhicule électrique, permettant ainsi la connexion électrique d'un véhicule électrique au système de station de recharge 10, et permettant plus précisément la fourniture d'un courant continu en provenance de l'unité de distribution de puissance 22 au véhicule électrique pour permettre sa recharge. Ainsi, lorsqu'un véhicule électrique est connecté à une prise 52, 62, le groupe de modules de puissance correspondant délivre un courant continu à la prise par l'intermédiaire du conducteur 40, 46 correspondant.

Les première et deuxième prises 52, 62 se présentent de préférence sous la forme de prises mâle, et sont par exemple conformes au standard « Combined Charging System », plus communément désigné par l'abréviation « CCS », ou au standard « CHAdeMO ». Selon un autre exemple, l'une des deux prises 52, 62 est conforme au standard CCS alors que l'autre des deux prises est conforme au standard CHAdeMO. Les prises 52, 62 peuvent également être conformes à d'autres standards non-décrits ici.

Grâce à la présence de deux prises distinctes, le système de station de recharge 10 permet la recharge simultanée de deux véhicules électriques. En pratique, l'unité de distribution de puissance 22 affecte les modules de puissance 18 au premier groupe, au deuxième groupe et au troisième groupe de modules de puissance en fonction de la puissance électrique requise pour recharger des véhicules électriques branchés sur les première et deuxième prises 52, 62. Par exemple, si deux véhicules nécessitant une puissance de recharge égale à trois fois la puissance nominale des modules de puissance 18 sont connectés aux prises 52, 62, alors l'unité de distribution de puissance 22 connecte trois modules de puissance 18 au premier groupe et trois modules de puissance 18 au deuxième groupe, de sorte que chaque véhicule puisse être rechargé le plus efficacement possible. Si un seul véhicule électrique est branché à l'une des deux prises 52, 62 et nécessite une puissance de recharge égale à deux fois la puissance nominale des modules de puissance, alors l'unité de distribution de puissance 22 connecte deux modules de puissance 18 au groupe correspondant à la prise utilisée. Dans cet exemple, les quatre autres modules de puissance sont de préférence attribués au troisième groupe, de sorte que la prise non-utilisée ne soit pas alimentée en courant continu.

Ainsi, en fonction des besoins, chacun des premier, deuxième et troisième groupes de modules de puissance peut comprendre entre zéro et six modules de puissance 18. Plus le nombre de modules de puissance raccordés à une prise 52, 62 est important, plus la puissance électrique pouvant être délivrée par cette prise à un véhicule électrique est importante.

De préférence, le câble à polarité positive 42 du premier conducteur 40 comprend un fusible 70 et le câble à polarité positive 48 du deuxième conducteur 46 comprend un fusible 71. Les fusibles 70, 71 permettent de protéger les premier et deuxième conducteurs ainsi que les première et deuxième prises 52, 62 en cas de défaillance du système de station de recharge 10 conduisant à la circulation d'un courant continu d'une puissance supérieure à la puissance maximale pouvant être supportée par les conducteurs et les prises.

De préférence, le câble à polarité positive 42 et le câble à polarité négative 44 du premier conducteur 40 comprennent respectivement un organe d'isolement 72A et un organe d'isolement 72B. Les organes d'isolement 72A, 72B sont opérables entre une position ouverte dans laquelle la circulation d'une tension et d'un courant dans le premier conducteur est empêchée, et une position fermée dans laquelle la circulation d'une tension et d'un courant dans le premier conducteur n'est pas empêchée. Ainsi en position ouverte des organes d'isolement, la première prise 52 est isolée du premier groupe de modules de puissance. Les organes d'isolement 72A, 72B permettent par exemple d'interrompre la circulation du courant continu délivré par le premier groupe de modules de puissance vers la première prise 52 lorsqu'un incident est détecté pendant la recharge d'un véhicule électrique connecté à la première prise. De même, le câble à polarité positive 48 et le câble à polarité négative 50 du deuxième conducteur 46 comprennent respectivement un organe d'isolement 73A et un organe d'isolement 73B.

De préférence, le système de station de recharge 10 comprend en outre un premier dispositif de contrôle d'isolation 74, connecté au câble à polarité positive 42 et au câble à polarité négative 44 du premier conducteur 40, ainsi qu'à une prise de terre 76, et comprend également un deuxième dispositif de contrôle d'isolation 78, connecté au câble à polarité positive 48 et au câble à polarité négative 50 du deuxième conducteur 46, ainsi qu'à une prise de terre 80. Chaque dispositif de contrôle d'isolation 74, 78 est apte à calculer une valeur d'impédance entre le câble à polarité positive associé et la prise de terre associée ; entre le câble à polarité négative associé et la prise de terre associée ; et/ou entre le câble à polarité positive associé et le câble à polarité négative associé.

Pour calculer une valeur d'impédance entre un câble à polarité positive et un câble à polarité négative, un dispositif de contrôle d'isolation injecte un signal de test dans le câble à polarité positive et mesure, sur le câble à polarité négative, le signal de retour provoqué par ce signal de test. Si l'isolation entre les câbles à polarité négative et positive était parfaite, aucun signal de retour ne serait mesuré. En réalité, cette isolation est toujours imparfaite, de sorte qu'un signal de retour de faible amplitude est mesuré, même lorsque l'isolation est satisfaisante. Ensuite, une valeur d'impédance entre les câbles à polarité positive et négative est calculé à partir du signal de test émis et du signal de retour mesuré. De préférence, le signal de test émis est un signal à haute fréquence, par exemple entre 1 kHz et 500 kHz - kilohertz -. De préférence, une valeur d'impédance représentative d'une bonne isolation entre les câbles à polarité positive et négative est supérieure à 250 kΩ - kiloohm -.

Le calcul d'une valeur d'impédance entre un câble à polarité positive et une prise de terre, ou entre un câble à polarité négative et une prise de terre, s'effectue de la même manière, en émettant le signal de test dans le câble à polarité positive ou négative et en mesurant le signal de retour au niveau de la prise de terre, ou bien en émettant le signal de test au niveau de la prise de terre et en mesurant le signal de retour dans le câble à polarité positive ou négative.

Les dispositifs de contrôle d'isolation 74, 78 permettent ainsi de vérifier l'intégrité de l'isolation des premier et deuxième conducteurs 40, 46, en détectant une éventuelle baisse d'impédance indicative d'une dégradation d'isolation. Par exemple, si une impédance inférieure à 250 kΩ est calculée entre un câble à polarité positive et un câble à polarité négative, alors l'isolation entre les câbles à polarité positive et négative est défaillante. En particulier, une impédance inférieure à 50 kΩ est représentative d'un câble à l'isolation très dégradée.

Le dispositif de contrôle d'isolation 74 est situé en aval des organes d'isolement 72A, 72B, c'est-à-dire qu'il est situé entre les organes d'isolement et la première prise 52. De même, le dispositif de contrôle d'isolation 78 est situé en aval des organes d'isolement 73A, 73B.

De préférence, le système de station de recharge 10 comprend en outre un premier compteur d'électricité 82, connecté au câble à polarité positive 42 et au câble à polarité négative 44 du premier conducteur 40 et un deuxième compteur d'électricité 84, connecté au câble à polarité positive 48 et au câble à polarité négative 50 du deuxième conducteur 46.

En pratique, chaque compteur d'électricité 82, 84 comprend un voltmètre et un ampèremètre, et est donc apte à mesurer la tension et l'intensité du courant continu circulant dans le conducteur 40, 46 respectif.

Le système de station de recharge 10 comprend en outre première unité de contrôle 86, associée à la première prise 52, et une deuxième unité de contrôle 88, associée à la deuxième prise 62. Chaque unité de contrôle 86, 88 contrôle le fonctionnement de la prise associée.

En outre, les unités de contrôle 86, 88 sont chacune connectées avec l'unité de distribution de puissance 22. Dans l'exemple, ces connexions s'effectuent par l'intermédiaire des premier et deuxième conducteurs 40, 46, par l'envoi de signaux de communication en modulation de courant porteur en ligne. En variante, les connexions entre les unités de contrôle 86, 88 et l'unité de distribution de puissance 22 s'effectuent par l'intermédiaire de fils de communication dédiés, étant soit intégrés aux premier et deuxième conducteurs, soit distincts des premier et deuxième conducteurs, ou bien par l'intermédiaire de liaisons sans fil.

De la même manière, les unités de contrôle 86, 88 sont chacune connectées avec les modules de puissance 18.

De préférence, la première prise 52 comporte des moyens de communication 90, qui sont connectés à la première unité de contrôle 86, et la deuxième prise 62 comporte des moyens de communication 92, qui sont connectés à la deuxième unité de contrôle 88. Ces moyens de communication 90, 92 sont prévus pour, lorsqu'une prise est connectée électriquement à un véhicule électrique, permettre la communication entre un véhicule électrique et l'unité de contrôle associée à ladite prise.

Lorsque la première unité de contrôle 86 détecte qu'un véhicule électrique est connecté à la première prise 52, notamment grâce aux moyens de communication 90, alors la première unité de contrôle 86 évalue la puissance électrique requise pour la recharge du véhicule électrique, contrôle l'unité de distribution de puissance 22 de sorte à attribuer des modules de puissance 18 au premier groupe de module de puissance, en commandant les groupes de relais 36, et commande les modules de puissance du premier groupe de modules de puissance de sorte à ce qu'ils délivrent un courant continu dont l'intensité et la tension sont adaptées pour recharger le véhicule électrique. De préférence, la première unité de contrôle 86 dialogue avec le véhicule électrique par l'émission de signaux de communication, permettant ainsi de surveiller le bon déroulement de la recharge du véhicule électrique. Ces signaux de communication comprennent par exemple des informations de fonctionnement du véhicule électrique et du système de station de recharge 10. Le fonctionnement de la deuxième unité de contrôle 88 est similaire à celui de la première unité de contrôle 86.

Avantageusement, les unités de contrôle 86, 88 sont respectivement connectées aux dispositifs de contrôle d'isolation 74, 78, et aux compteurs d'électricité 82, 84. Ainsi, les calculs d'impédance réalisés par les dispositifs de contrôle d'isolation et les mesures réalisées par les compteurs d'électricité sont collectés et analysés par les unités de contrôle correspondantes.

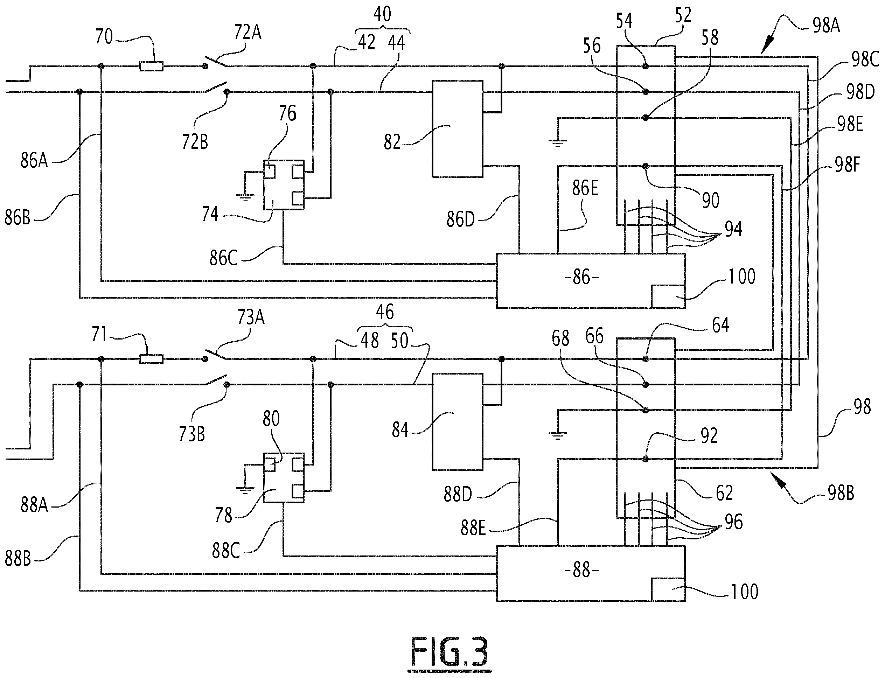

Sur les figures 1 et 3, les unités de contrôle 86, 88 sont représentées distinctes des prises 52, 62 et des conducteurs 40, 46. Ainsi, la première unité de contrôle 86 est représentée connecté aux câbles 42 et 44 du premier conducteur par des fils 86A, 86B, connectée au premier dispositif de contrôle d'isolation 74 par un fil 86C, connectée au premier compteur d'électricité 82 par un fil 86D et connectée aux moyens de communication 90 de la première prise 52 par un fil 86E. De même, la deuxième unité de contrôle 88 est représentée connectée aux câbles 48, 50 du deuxième conducteur par des fils 88A, 88B, connectée au deuxième dispositif de contrôle d'isolation 78 par un fil 88C, connectée au deuxième compteur d'électricité 84 par un fil 88D et connectée aux moyens de communication 92 de la deuxième prise 62 par un fil 88E. En variante, les unités de contrôle 86, 88 sont directement intégrées aux prises 52, 62, ou montées directement sur les conducteurs 40, 46.

Avantageusement, la première prise 52 comprend quatre capteurs de température 94. Parmi les quatre capteurs de température, deux mesurent la température de la première prise au niveau du point de connexion positif 54, et deux mesurent la température de la première prise au niveau du point de connexion négatif 56. Ainsi, les mesures de température sont redondantes, ce qui permet de détecter une défaillance éventuelle d'un capteur de température. Les quatre capteurs de température 94 sont connectés à la première unité de contrôle 86, permettant à la première unité de contrôle de collecter les mesures de températures. De même, la deuxième prise 62 comprend quatre capteurs de température 96, qui sont connectés à la deuxième unité de contrôle 88.

On décrit à présent une méthode de diagnostic du système de station de recharge 10, qui vise à tester le système de station de recharge de manière à vérifier son bon fonctionnement. Cette méthode de diagnostic est mise en oeuvre lorsqu'aucun véhicule électrique n'est connecté aux prises 52, 62.

La méthode de diagnostic comprend une première étape de connexion, qui consiste à connecter la première prise 52 à la deuxième prise 62, et plus précisément à connecter le point de connexion positif 54 de la première prise avec le point de connexion positif 64 de la deuxième prise, à connecter le point de connexion négatif 56 de la première prise avec le point de connexion négatif 66 de la deuxième prise, à connecter le point de connexion de terre 58 de la première prise avec le point de connexion de terre 68 de la deuxième prise, et, de préférence, à connecter les moyens de communication 90 de la première prise 52 aux moyens de communication 92 de la deuxième prise 62, de manière à former une boucle comprenant :
- les première et deuxième prises,
- les premier et deuxième conducteurs,
- l'unité de distribution de puissance 22, et
- le premier et le deuxième groupes de modules de puissance.

De manière particulièrement avantageuse, pour connecter la première prise 52 avec la deuxième prise 62, le système de station de recharge 10 comprend des moyens de connexion dédiés. Dans l'exemple, ces moyens de connexion sont formés par un outil de connexion 98. L'outil de connexion 98 se présente par exemple sous la forme d'un câble ou d'un boîtier. Il présente un premier embout femelle 98A, adapté pour être connecté à la première prise 52, et un deuxième embout femelle 98B, adapté pour être connecté à la deuxième prise 62.

En pratique, l'outil de connexion 98 comprend :
- un câble positif 98C, qui connecte le point de connexion positif 54 de la première prise 52 au point de connexion positif 64 de la deuxième prise 62 ;
- un câble négatif 98D, qui connecte le point de connexion négatif 56 de la première prise 52 au point de connexion négatif 66 de la deuxième prise 62 ;
- un câble de terre 98E, qui connecte le point de connexion de terre 58 de la première prise 52 au point de connexion de terre 68 de la deuxième prise 62 ; et
- de préférence, un câble de communication 98F, qui connecte les moyens de communication 90 de la première prise 52 aux moyens de communication 92 de la deuxième prise 62.

La méthode de diagnostic comprend ensuite une étape de test, qui consiste à émettre au moins une grandeur électrique circulant au moins de la première prise 52 vers la deuxième prise 62 et à mesurer des états de fonctionnement d'une partie au moins des éléments de la boucle en réaction à la grandeur électrique émise.

La méthode de diagnostic comprend ensuite une étape d'analyse, qui consiste à réaliser un diagnostic desdits composants sur la base des mesures des états de fonctionnement.

Cette méthode de diagnostic permet de diagnostiquer divers composants du système de station de recharge 10, en fonction de la ou des grandeurs électriques émises au cours de l'étape de test, et en fonction de la ou des diagnostics réalisés au cours de l'étape d'analyse.

Un premier diagnostic réalisable grâce à la méthode de diagnostic est un diagnostic simultané de l'intégrité de l'isolation des premier et deuxième conducteurs 40, 46 et de la fiabilité des dispositifs de contrôle d'isolation 74, 78.

L'étape de test comporte une phase d'ouverture, pendant laquelle les organes d'isolement 73A et 73B sont maintenus en position ouverte, de sorte que la deuxième prise 62 est isolée du deuxième groupe de modules de puissance.

Pour effectuer ce premier diagnostic, l'étape de test comprend, pendant la phase d'ouverture, l'émission d'un signal de test par le premier dispositif de contrôle d'isolation 74 dans le premier conducteur 40 vers la première prise 52. Ce signal de test est établi dans les premier et deuxième conducteurs 40, 46, dans les première et deuxième prises 52, 62 et dans l'outil de connexion 98.

Ensuite, au cours de l'étape d'analyse, le diagnostic est réalisé en comparant entre elles :
a) une valeur d'impédance entre le câble à polarité positive 42 du premier conducteur et la prise de terre 76 du premier dispositif de contrôle d'isolation 74 avec une valeur d'impédance entre le câble à polarité positive 48 du deuxième conducteur 46 et la prise de terre 80 du deuxième dispositif de contrôle d'isolation 78, les valeurs d'impédance étant calculées pendant la phase d'ouverture par les premier et deuxième dispositifs de contrôle d'isolation,
b) et/ou une valeur d'impédance entre le câble à polarité négative 44 du premier conducteur et la prise de terre 76 du premier dispositif de contrôle d'isolation 74 avec une valeur d'impédance entre le câble à polarité négative 50 du deuxième conducteur 46 et la prise de terre 80 du deuxième dispositif de contrôle d'isolation 78, les valeurs d'impédance étant calculées pendant la phase d'ouverture par les premier et deuxième dispositifs de contrôle d'isolation,
c) et/ou une valeur d'impédance entre les câbles à polarité positive 42 et négative 44 du premier conducteur avec une valeur d'impédance entre les câbles à polarité positive 48 et négative 50 du deuxième conducteur 46, les valeurs d'impédance étant calculées pendant la phase d'ouverture par les premier et deuxième dispositifs de contrôle d'isolation,
les valeurs d'impédance étant calculées par les dispositifs de contrôle d'isolation à partir du signal de test émis et du signal de retour mesuré, comme décrit ci-dessus.

En pratique, si les valeurs d'impédance calculées par le premier dispositif de contrôle d'isolation 74 sont identiques, ou sensiblement identiques, aux valeurs d'impédance calculées par le deuxième dispositif de contrôle d'isolation 78, alors il est conclu que le fonctionnement des premier et deuxième dispositifs de contrôle d'isolation est fiable. En effet, une défaillance de l'un des deux dispositifs de contrôle d'isolation entraînerait une divergence entre leurs calculs valeurs d'impédance.

En outre, si les valeurs d'impédance a) calculées par les premier et deuxième dispositifs de contrôle d'isolation 74, 78 sont sensiblement identiques et proches d'une valeur seuil prédéterminée, alors il est conclu que l'intégrité de l'isolation des premier et deuxième conducteurs entre leurs câbles à polarité positive et la terre est préservée. Dans le cas d'une différence importante entre les valeurs d'impédance a) et la valeur seuil prédéterminée, il est conclu que l'isolation du premier conducteur et/ou du deuxième conducteur est dégradée, et qu'un examen plus poussé des premier et deuxième conducteurs est requis pour effectuer une réparation ou un remplacement. De même, les valeurs d'impédance b) permettent de vérifier l'intégrité de l'isolation des premier et deuxième conducteurs entre leurs câbles à polarité négative et la terre, et les valeurs d'impédance c) permettent de vérifier l'intégrité de l'isolation des premier et deuxième conducteurs entre leurs câbles à polarité positive et leurs câbles à polarité négative.

Le premier diagnostic peut également être réalisé en ouvrant les organes d'isolement 72A et 72B et en faisant émettre un signal de test au deuxième dispositif de contrôle d'isolation 78.

En résumé, au cours du premier diagnostic, la grandeur électrique émise est un signal de test émis par le premier dispositif de contrôle d'isolation 74 et les états de fonctionnement mesurés sont des valeurs d'impédance, calculées à partir du signal de test et d'un signal de retour provoqué par le signal de test.

Un deuxième diagnostic réalisable grâce à la méthode de diagnostic est un diagnostic de bon fonctionnement des organes d'isolement 73A et 73B. Pour réaliser ce deuxième diagnostic, au moins un module de puissance 18 est associé au premier groupe de modules de puissance et au moins un module de puissance 18 est associé au deuxième groupe de modules de puissance.

Au cours de ce deuxième diagnostic, l'étape de test comporte une phase d'ouverture, pendant laquelle les organes d'isolement 73A et 73B sont maintenus en position ouverte, de sorte que la deuxième prise 62 est isolée du deuxième groupe de modules de puissance. La phase d'ouverture du deuxième diagnostic peut être la même phase d'ouverture que celle du premier diagnostic, ou bien une phase d'ouverture différente de celle du premier diagnostic.

Pour effectuer ce premier diagnostic, l'étape de test comprend, pendant la phase d'ouverture, l'émission d'une tension continue par le premier groupe de modules de puissance vers la première prise 52. Cette tension est établie dans les premier et deuxième conducteurs 40, 46, dans les première et deuxième prises 52, 62 et dans l'outil de connexion 98. Cette tension est dite « à vide », car aucune charge électrique n'est connectée au premier groupe de modules de puissance.

Lorsque la phase d'ouverture du deuxième diagnostic est la même phase d'ouverture que celle du premier diagnostic, la tension continue est émise soit simultanément, soit en différée, du signal de test.

Ensuite, au cours de la phase d'ouverture de l'étape de test, on effectue une mesure de tension aux bornes de sortie du module de puissance appartenant au deuxième groupe, cette mesure étant effectuée par le voltmètre embarqué par le module de puissance.

Ensuite au cours de l'étape d'analyse, on vérifie si la tension mesurée pendant la phase d'ouverture aux bornes de sortie du module de puissance est nulle, ou sensiblement nulle. Si cette tension est nulle ou sensiblement nulle, alors il est conclu qu'il n'existe pas de fuite de tension au travers des organes d'isolement 73A et 73B, et donc que les organes d'isolement fonctionnent bien. Dans le cas contraire, il est conclu que le fonctionnement des organes d'isolement 73A et 73B est défaillant, et qu'il est nécessaire de les réparer ou de les remplacer.

Le deuxième diagnostic peut également être réalisé pour tester le fonctionnement des organes d'isolement 72A et 72B, en ouvrant les organes d'isolement 72A et 72B et en faisant émettre une tension au deuxième groupe de modules de puissance, qui comprend alors au moins un module de puissance 18.

En résumé, au cours du deuxième diagnostic, la grandeur électrique émise est une tension émise par le premier groupe de modules de puissance et les états de fonctionnement mesurés sont des valeurs de tension.

Un troisième diagnostic réalisable grâce à la méthode de diagnostic est un diagnostic d'intégrité des organes d'isolement 73A et 73B.

Au cours de ce troisième diagnostic, chacun des premier et deuxième groupes de modules de puissance comporte au moins un module de puissance 18. En outre, l'étape de test comporte une phase de fermeture, pendant laquelle les organes d'isolement 73A et 73B sont maintenus en position fermée, de sorte que la deuxième prise 62 est connectée au deuxième groupe de modules de puissance.

Pour effectuer ce troisième diagnostic, l'étape de test comprend, pendant la phase de fermeture, l'émission d'une tension continue par le premier groupe de modules de puissance vers la première prise 52. Cette tension est établie dans les premier et deuxième conducteurs 40, 46, dans les première et deuxième prises 52, 62 et dans l'outil de connexion 98, et circule dans la boucle jusqu'au deuxième groupe de modules de puissance.

Ensuite, au cours de la phase de fermeture de l'étape de test, on effectue une mesure de tension aux bornes de sortie du module de puissance appartenant au deuxième groupe, cette mesure étant effectuée par le voltmètre embarqué par le module de puissance, et une mesure de tension au niveau du deuxième conducteur 46, cette mesure étant effectuée par le deuxième compteur d'électricité 84.

Ensuite, au cours de l'étape d'analyse, le diagnostic est réalisé en comparant entre elles la tension mesurée par le voltmètre du module de puissance 18 pendant la phase de fermeture avec une tension mesurée par le deuxième compteur d'électricité 84 pendant la phase de fermeture. Si ces deux tensions sont égales ou sensiblement égales, alors il est conclu que l'intégrité des organes d'isolement 73A et 73B est préservée, car ils n'agissent pas comme des résistances lorsqu'ils sont en position fermée. Dans le cas contraire, il est conclu que le fonctionnement des organes d'isolement 73A et 73B est défaillant, et qu'il est nécessaire de les réparer ou de les remplacer.

Le troisième diagnostic peut également être réalisé pour tester le fonctionnement des organes d'isolement 72A et 72B, en mesurant au cours de la phase de fermeture la tension de part et d'autre des organes d'isolement 72A et 72B, à l'aide du voltmètre embarqué dans les modules de puissance du premier groupe de modules de puissance et à l'aide du premier compteur d'électricité 82.

Les deuxième et troisième diagnostics sont ainsi complémentaires pour vérifier le bon fonctionnement des organes d'isolement 72A, 72B, 73A, 73B, c'est-à-dire pour vérifier qu'ils fonctionnent correctement en position ouverte, c'est-à-dire qu'ils interrompent complètement une circulation de courant, et qu'ils fonctionnent correctement en position fermée, c'est-à-dire qu'ils permettent une circulation de courant sans y résister.

En résumé, au cours du troisième diagnostic, la grandeur électrique émise est une tension émise par le premier groupe de modules de puissance et les états de fonctionnement mesurés sont des valeurs de tension.

Un quatrième diagnostic réalisable grâce à la méthode de diagnostic est un diagnostic de l'intégrité des moyens de communication 90, 92 des première et deuxième prises 52, 62.

Pour réaliser ce quatrième diagnostic, il n'est pas nécessaire que des modules de puissance 18 soient affectés aux premier et deuxième groupes de modules de puissance.

Dans ce quatrième diagnostic, l'étape de test comprend une phase de communication, au cours de laquelle un signal de communication est émis par la première unité de contrôle 86, ce premier signal de communication circulant ensuite par les première et deuxième prises 52, 62 et par l'outil de connexion 98 jusqu'à la deuxième unité de contrôle 88.

Ensuite au cours de l'étape d'analyse, on vérifie l'intégrité des moyens de communication 90, 92, à l'aide des méthodes suivantes.

Une première méthode consiste à comparer le signal de communication émis par la première unité de contrôle avec le signal de communication reçu par la deuxième unité de contrôle. Cette première méthode permet de détecter une éventuelle dégradation ou perte du signal de communication transmis par les première et deuxième prises 52, 62, et donc de déterminer que le remplacement ou la réparation des moyens de communication 90, 92 est nécessaire.

Une deuxième méthode consiste à faire émettre par la première unité de contrôle 86 un signal de communication appelant une réponse, et à analyser un signal de réponse émis par la deuxième unité de contrôle 88 en réaction à la réception du signal de communication. Cette deuxième méthode permet de détecter une éventuelle défaillance des moyens de communication 90, 92, mais également de la deuxième unité de contrôle 88, notamment dans le cas où un signal de réponse est reçu par la première unité de contrôle 86, mais ne correspond pas au signal qui aurait dû être émis par la deuxième unité de contrôle 88. Par exemple, le signal de communication émis correspond à un signal émis par un véhicule électrique en cas de défaut se produisant au cours de sa recharge, ce qui permet de vérifier que la deuxième unité de contrôle 88 reçoit bien ce signal de défaut, et réagit bien suite à la réception de ce signal.

Le quatrième diagnostic peut être réalisé en utilisant l'une ou l'autre de ces deux méthodes, ou bien en utilisant ces deux méthodes.

La deuxième méthode a l'avantage de permettre la réalisation de tests plus poussés du système de station de recharge 10. Par exemple, le signal de communication émis par la première unité de contrôle 86 peut simuler le fonctionnement d'un véhicule électrique, de manière à faire croire à la deuxième unité de contrôle 88 qu'une recharge de véhicule électrique est en cours. Ainsi, il est possible de tester le comportement de la deuxième unité de contrôle 88 lors de la charge d'un véhicule électrique, sans avoir besoin d'effectuer une recharge réelle d'un véhicule électrique.

En outre, le signal de communication émis par la première unité de contrôle 86 peut simuler des défauts pouvant se produire pendant la recharge d'un véhicule électrique, de manière à analyser le comportement de la deuxième unité de contrôle 88 face à la détection d'un tel défaut. Par exemple, il est possible de simuler une température de batterie d'un véhicule électrique élevée, un défaut de sur-courant au niveau de la batterie d'un véhicule électrique, ou encore un défaut de verrouillage de la première prise 52 à un véhicule électrique.

Le quatrième diagnostic peut également être réalisé pour tester le fonctionnement de la première unité de contrôle 86, en faisant émettre le signal de communication par la deuxième unité de contrôle 88 et en l'analysant selon la deuxième méthode.

En résumé, au cours du quatrième diagnostic, la grandeur électrique émise est un signal de communication émis par la première unité de contrôle 86 et les états de fonctionnement mesurés sont des signaux reçus par les unités de contrôle 86, 88 en réponse à ce signal de communication.

Un cinquième diagnostic réalisable grâce à la méthode de diagnostic est un diagnostic de fiabilité des compteurs d'électricité 82, 84.

Au cours de ce cinquième diagnostic, les premier et deuxième groupes de modules de puissance comportent chacun au moins un module de puissance 18. Par exemple, chacun des premier et deuxième groupes de modules de puissance comporte trois modules de puissance. En outre, les organes d'isolement 72A, 72B, 73A et 73B sont maintenus en position fermée.

Pour effectuer ce cinquième diagnostic, l'étape de test comprend une phase de circulation de courant, au cours de laquelle le premier groupe de modules de puissance émet un courant continu, qui circule dans la boucle jusqu'au deuxième groupe de modules de puissance. Le courant ainsi reçu par le deuxième groupe de modules de puissance est ensuite converti en courant alternatif par le deuxième groupe de modules de puissance.

Au cours de la phase de circulation de courant, la tension et l'intensité du courant continu circulant dans les premier et deuxième conducteurs 40, 46 sont mesurées par les compteurs d'électricité 82, 84 respectivement.

Ensuite, au cours de l'étape d'analyse, on compare la tension mesurée par le premier compteur d'électricité 82 à la tension mesurée par le deuxième compteur d'électricité 84, en vérifiant si la tension mesurée par le premier compteur d'électricité est bien égale, ou sensiblement égale, à l'inverse de la tension mesurée par le deuxième compteur d'électricité. Si tel est le cas, on conclut que les voltmètres des premier et deuxième compteurs d'électricité fonctionnent correctement. Dans le cas contraire, on conclut à une défaillance du voltmètre du premier compteur d'électricité et/ou à une défaillance du voltmètre du deuxième compteur d'électricité.

De manière analogue, au cours de l'étape d'analyse, on compare l'intensité mesurée par le premier compteur d'électricité 82 à l'intensité mesurée par le deuxième compteur d'électricité 84, en vérifiant si l'intensité mesurée par le premier compteur d'électricité est bien égale, ou sensiblement égale, à l'inverse de l'intensité mesurée par le deuxième compteur d'électricité. Si tel est le cas, on conclut que les ampèremètres des premier et deuxième compteurs d'électricité fonctionnent correctement. Dans le cas contraire, on conclut à une défaillance de l'ampèremètre du premier compteur d'électricité et/ou à une défaillance de l'ampèremètre du deuxième compteur d'électricité.

En effet, le courant continu émis par le premier groupe de modules de puissance est transmis au deuxième groupe de modules de puissance par l'intermédiaire des conducteurs 40, 46 et des prises 52, 62 sans qu'aucune consommation significative d'énergie n'ait lieu, car la boucle ne comporte pas de charge électrique susceptible de consommer de l'énergie. En pratique, il existe des déperditions d'énergie dans la boucle, liées notamment à l'effet Joule, mais ces déperditions sont relativement faibles comparées à la puissance pouvant être fournie par le premier groupe de modules de puissance. Dès lors, si les compteurs d'électricité 82 et 84 fonctionnent correctement, les mesures du premier compteur d'électricité sont sensiblement égales à l'inverse des mesures du deuxième compteur d'électricité.

En résumé, au cours du cinquième diagnostic, la grandeur électrique émise est un courant continu, émis par le premier groupe de modules de puissance, et les états de fonctionnement mesurés sont des valeurs de tension et d'intensité.

Un sixième diagnostic réalisable grâce à la méthode de diagnostic est un diagnostic de surchauffe des première et deuxième prises 52, 62.

Au cours de ce sixième diagnostic, les premier et deuxième groupes de modules de puissance comportent chacun au moins un module de puissance 18. Par exemple, chacun des premier et deuxième groupes de modules de puissance comporte trois modules de puissance. En outre, les organes d'isolement 72A, 72B, 73A et 73B sont maintenus en position fermée.

Pour effectuer ce sixième diagnostic, l'étape de test comprend une phase de circulation de courant, qui est soit la même que celle du cinquième diagnostic, soit indépendante mais identique à celle du cinquième diagnostic. Ainsi, le sixième diagnostic peut être réalisé simultanément, ou indépendamment, du cinquième diagnostic.

Au cours de la phase de circulation de courant, la température des première et deuxième prises 52, 62 est mesurée par les capteurs de température 94, 96 respectivement.

Ensuite, au cours de l'étape d'analyse, on analyse les mesures de température réalisées au cours de la phase de circulation de courant pour détecter une éventuelle surchauffe de la première prise et/ou de la deuxième prise. Cette analyse est par exemple réalisée en comparant les mesures de température à des valeurs de référence, ou en étudiant l'évolution des mesures de température au cours de la phase de circulation de courant, une élévation rapide de température pouvant indiquer une surchauffe.

Au cours du sixième diagnostic, il est également possible de ne surveiller que la surchauffe de la première prise 52 ou de la deuxième prise 62, en ne réalisant des mesures de température qu'avec les capteurs de température 94, 96 correspondants.

En résumé, au cours du sixième diagnostic, la grandeur électrique émise est un courant continu, émis par le premier groupe de modules de puissance, et les états de fonctionnement mesurés sont des valeurs de température des première et deuxième prises 52, 62.

Un septième diagnostic réalisable grâce à la méthode de diagnostic est un diagnostic de résistance à la surcharge des modules de puissance du deuxième groupe de modules de puissance.

Au cours de ce septième diagnostic, le deuxième groupe de modules de puissance comporte au moins un module de puissance 18, et le premier groupe de modules de puissance comporte au moins deux modules de puissance 18, de sorte que le premier groupe comporte au moins un module de puissance de plus que le deuxième groupe. Par exemple, le premier groupe de modules de puissance comporte quatre modules de puissance 18 et le deuxième groupe de modules de puissance comporte deux modules de puissance. En outre, les organes d'isolement 72A, 72B, 73A et 73B sont maintenus en position fermée.

Pour effectuer ce septième diagnostic, l'étape de test comprend une phase de circulation de courant, qui est soit la même que celle des cinquième et sixième diagnostics, soit indépendante mais identique à celles des cinquième et sixième diagnostics. Ainsi, le septième diagnostic peut être réalisé simultanément, ou indépendamment, des cinquième et sixième diagnostics.

Les modules de puissance du premier groupe de modules de puissance sont commandés de sorte que, au cours de la phase de circulation de courant, la puissance électrique du courant continu circulant dans la boucle dépasse la puissance nominale du deuxième groupe de modules de puissance, c'est-à-dire à la somme de la puissance nominale de chacun des modules de puissance du deuxième groupe, d'au moins 5%, de préférence d'au moins 10%.

Par exemple, si la puissance nominale des modules de puissance est égale à 30 kilowatt, si le premier groupe comporte quatre modules de puissance 18 et que le deuxième groupe comporte deux modules de puissance 18, alors le premier groupe de modules de puissance émet un courant continu dont la puissance est égale à 63 kilowatt, de préférence égale à 66 kilowatt. On remarque que cette puissance est inférieure à la puissance maximale délivrée par le premier groupe de modules de puissance, qui est égale à 120 kilowatt.

Ainsi, les modules de puissance du deuxième groupe de modules de puissance sont mis en surcharge.

Ensuite, au cours de la phase de circulation de courant, des grandeurs caractéristiques du fonctionnement des modules de puissance 18 du deuxième groupe de modules de puissance sont mesurées. Il peut s'agir, par exemple, de mesures de températures réalisées grâce à des capteurs de température intégrés aux modules de puissance, ou encore des signaux représentatifs du bon état de fonctionnement de composants de puissance intégrés aux modules de puissance 18, ces composants étant par exemple des transistors de commutation ou des condensateurs.

Ensuite, au cours de l'étape d'analyse, on analyse les grandeurs caractéristiques mesurées au cours de la phase de circulation de courant pour détecter une éventuelle défaillance des modules de puissance du deuxième groupe de modules de puissance. Par exemple, si une température supérieure à un seuil prédéterminé est détectée au sein de l'un des modules de puissance, alors il est conclu que ce module de puissance n'est pas en mesure de résister à une surcharge, et qu'une réparation ou un remplacement est nécessaire.

Le septième diagnostic peut également être réalisé pour tester la résistance à la surcharge des modules de puissance du premier groupe de modules de puissance, en faisant émettre un courant continu au deuxième groupe de modules de puissance dont la puissance est supérieure à la puissance nominale du premier groupe de modules de puissance.

En résumé, au cours du septième diagnostic, la grandeur électrique émise est un courant continu, émis par le premier groupe de modules de puissance, et les états de fonctionnement mesurés sont des grandeurs caractéristiques du fonctionnement des modules de puissance 18 du deuxième groupe de modules de puissance.

Au cours des cinquième, sixième et septième diagnostics, le courant continu reçu par le deuxième groupe de modules de puissance et transformé en courant alternatif est soit réinjecté dans le réseau électrique, soit fourni au premier groupe de modules de puissance par l'intermédiaire du système de distribution 20.

Pour diminuer la consommation énergétique de la méthode de diagnostic, le courant alternatif produit par le deuxième groupe de modules de puissance à partir du courant continu reçu au cours de la phase de circulation de courant de l'étape de test est préférentiellement fourni au premier groupe de modules de puissance. Ainsi, le premier groupe de modules de puissance est essentiellement alimenté en courant alternatif par le deuxième groupe de modules de puissance. Du fait de la présence de déperditions d'énergie dans la boucle, liées notamment à l'effet Joule, et d'un rendement imparfait des modules de puissance 18, la totalité de la puissance électrique du courant continu injecté dans la boucle par le premier groupe de modules de puissance n'est pas récupérée puis transformée en courant alternatif par le deuxième groupe de modules de puissance. En pratique, ces pertes s'élèvent à environ 10%, de préférence environ 5%, du courant alternatif consommé par le premier groupe de modules de puissance. Autrement dit, le rendement du système de station de recharge 10 au cours de la phase de circulation de courant de l'étape de test est d'environ 90%, de préférence d'environ 95%.

Ainsi, la totalité de la puissance électrique consommée par le premier groupe de modules de puissance ne peut pas être fournie par le deuxième groupe de modules de puissance. Le premier groupe de modules de puissance est alors alimenté partiellement par le deuxième groupe de modules de puissance, et partiellement par le réseau électrique. En pratique, compte-tenu du rendement décrit ci-dessus, au moins 90%, de préférence au moins 95%, de la puissance électrique consommée par le premier groupe de modules de puissance est délivrée au premier groupe de modules de puissance par le deuxième groupe de modules de puissance. Ainsi, la consommation d'énergie électrique provenant du réseau électrique est très réduite, et cette consommation sert en pratique à compenser les pertes du système de station de recharge 10.

Cette autoconsommation est très avantageuse, car l'énergie électrique consommée par le premier groupe de modules de puissance lors de la méthode de diagnostic de l'invention n'est pas perdue, contrairement à l'énergie électrique consommée par les méthodes de diagnostic connues, dans lesquelles cette énergie électrique est perdue dans le rechargement de la batterie d'un véhicule électrique, ou perdue par effet Joule dans une charge électrique.

Dès lors, un autre avantage de l'invention est de permettre de diagnostiquer le bon fonctionnement d'un système de station de recharge avant le raccordement de ce système de station de recharge à un réseau électrique de forte puissance, par exemple avant sa mise en service initiale. En effet, seule une faible puissance provenant du réseau électrique est nécessaire pour exécuter les cinquième, sixième et septième diagnostics décrits ci-dessus, et les premier à quatrième diagnostics décrits ci-dessus ne nécessitent pas de consommation électrique significative du système de station de recharge pour leur mise en oeuvre.

En outre, un autre avantage de la méthode de diagnostic de l'invention est de permettre la réalisation de tests d'endurance du système de station de recharge 10, en faisant par exemple émettre au premier groupe de modules de puissance un courant électrique sur une longue durée. En effet, compte-tenu de la faible consommation énergétique de la méthode de diagnostic de l'invention, de tels tests d'endurance sont réalisables à un coût attractif, ce qui n'est pas le cas avec les méthodes de diagnostic connues, pour lesquelles l'exécution d'un test d'endurance entraînerait une consommation énergétique élevée.

De plus, la méthode de diagnostic de l'invention est peu onéreuse à mettre en oeuvre, car l'outil de connexion 98 est particulièrement simple et peu onéreux à fabriquer, et la méthode de diagnostic ne nécessite pas le recours à d'autres matériels. Ainsi, l'utilisation d'une charge électrique ou d'une voiture électrique dont la batterie est déchargée, comme cela est réalisé dans les méthodes de diagnostic connues, est évitée.

Par ailleurs, la méthode de diagnostic peut incorporer en plusieurs étapes successives toute combinaison des diagnostics décrits ci-dessus. Ainsi, grâce à l'invention, il est possible de diagnostiquer la plupart des composants du système de station de recharge 10 à l'aide d'une seule méthode.

Grâce à la méthode de diagnostic de l'invention, d'autres diagnostics plus complexes peuvent en outre être réalisés. Par exemple, il est possible de simuler complètement le fonctionnement d'un véhicule électrique en cours de recharge avec le deuxième groupe de modules de puissance, qui simule alors la consommation d'énergie du véhicule électrique, et avec la deuxième unité de contrôle 88 et les moyens de communication 92, qui simule alors les communications et données du véhicule électrique. Ainsi, la première unité de contrôle 86 se comporte comme si la recharge d'un véhicule électrique était en cours, ce qui permet de diagnostiquer tous les éléments de la boucle depuis le premier groupe d'unités de contrôle jusqu'à la première prise 52 dans des conditions sensiblement identiques à des conditions réelles de recharge d'un véhicule électrique. Autrement dit, la méthode de diagnostic de l'invention permet de simuler un dialogue entre une station de recharge et un véhicule électrique simplement en connectant les première et deuxième prises 52, 62 l'une à l'autre.

Il est également possible de tester certains composants du système de station de recharge 10 avec des tests dynamiques, en faisant par exemple émettre au premier groupe de modules de puissance, au cours de l'étape de test, une rampe de tension et/ou une rampe de courant

Avantageusement, la première unité de contrôle 86 et/ou la deuxième unité de contrôle 88 comprend un module de commande 100 qui exécute les étapes de test et d'analyse de la méthode de diagnostic de l'invention. Dans l'exemple, chaque module de commande 100 est un processeur, et sera désigné ainsi dans la suite de la description. En variante non-représentée de l'invention, chaque module de commande 100 est un microprocesseur, un automate, un circuit intégré propre à une application, plus couramment désigné par l'acronyme anglais ASIC (application-specific integrated circuit), ou encore un circuit intégré reprogrammable, plus couramment désigné par l'acronyme anglais FPGA (field-programmable gate array).

Autrement dit, la ou les grandeurs électriques, telles qu'une tension, un courant ou un signal de communication, émises par le premier groupe de modules de puissance et/ou par la première unité de contrôle 86 sont émises sur instruction du processeur 100 de la première unité de contrôle 86 ou sur instruction du processeur 100 de la deuxième unité de contrôle 88, et la ou les analyses réalisées au cours de l'étape d'analyse sont réalisées par ce processeur.

Autrement dit, mise à part l'étape de connexion qui nécessite une intervention physique sur le système de station de recharge 10, la méthode de diagnostic est exécutée par le processeur 100.

De préférence, les premier à septième diagnostics sont enregistrés dans une mémoire accessible par le processeur 100 sous forme d'instructions exécutables par le processeur. Ainsi, la méthode de diagnostic est démarrée par exemple à l'aide d'une interface de commande du système de station de recharge 10, ou bien à l'aide d'une interface de communication, tel qu'une connexion avec un ordinateur distant ou bien connecté au système de station de recharge. Alternativement, les instructions permettant au processeur d'exécuter la méthode de diagnostic sont fournies au processeur 100 directement par un ordinateur ou un serveur distant connecté au processeur.

En variante non-représentée de l'invention, le processeur 100 exécutant la méthode de diagnostic est embarqué dans l'unité de distribution de puissance 22, ou à un autre emplacement du système de station de recharge 10.

En variante non-représentée de l'invention, les modules de puissance 18 n'intègrent pas de compteur d'électricité, mais l'unité de puissance 22 intègre un premier compteur d'électricité apte à mesurer une tension et une intensité au niveau de la première borne de sortie 24, et un deuxième compteur d'électricité apte à mesurer une tension et une intensité au niveau de la deuxième borne de sortie 30.

En variante non-représentée de l'invention, les organes d'isolement 72A, 72B, 73A et 73C ne sont pas intégrés aux premier et deuxième conducteurs 40 et 46, mais sont intégrés à l'unité de puissance 22, entre les groupes de relais 36 et les première et deuxième bornes de sortie 24, 30.

En variante non-représentée de l'invention, les première et deuxième prises 52, 62 ne comprennent pas de point de connexion de terre 58, 68 et ne sont donc pas connectées à la terre.

En variante non-représentée de l'invention, les première et deuxième prises 52, 62 comprennent un nombre différent de capteurs de température 94, 96, par exemple deux capteurs de température par prise, avec un premier capteur mesurant la température de la prise au niveau du point de connexion positif, et un deuxième capteur mesurant la température de la prise au niveau du point de connexion négatif, ou encore un seul capteur de température par prise, mesurant la température d'un boîtier de la prise.

En variante non-représentée de l'invention, les capteurs de température 94, 96 ne sont pas disposés dans les première et deuxième prises 52, 62, mais sont intégrés au premier et deuxième conducteurs 40, 46. Dans une telle variante, les capteurs de température sont ainsi utilisés pour détecter une surchauffe des conducteurs

En variante non-représentée de l'invention, les première et deuxième prises 52, 62 ne comprennent pas de moyens de communication 90, 92 dédiés, et les communications avec les unités de contrôle 86, 88 passent par les points de connexion positif 54, 64 et négatif 56, 66 des prises, en modulation de courant porteur en ligne. Autrement dit, dans une telle variante, les moyens de communication des prises sont virtuels et formés par les signaux de communication en modulation de courant porteur en ligne passant par les prises.

En variante non-représentée de l'invention, le système de station de recharge 10 comprend un nombre de modules de puissance 18 différent de six, par exemple quatre, cinq ou huit modules de puissance. En pratique, le système de station de recharge 10 comprend au moins deux modules de puissance 18, de sorte à permettre la recharge simultanée de deux véhicules électriques.

En variante non-représentée de l'invention, le système de station de recharge 10 comprend une unique unité de contrôle, qui regroupe les première et deuxième unités de contrôle 86, 88.

En variante non-représentée de l'invention, le système de station de recharge 10 comprend plus de deux prises, par exemple trois prises ou quatre prises, permettant ainsi la recharge simultanée de plus de deux véhicules électriques, et comprend un nombre correspondant de conducteurs. Dans une telle variante, il est possible de diagnostiquer le fonctionnement de l'ensemble des prises et connecteurs associés en réalisant successivement la méthode de diagnostic de l'invention, en branchant alternativement les prises entre elles deux à deux.

En variante non-représentée de l'invention, le système de station de recharge 10 présente une première prise femelle, qui est reliée à la première prise 52, et/ou une deuxième prise femelle, qui est reliée à la deuxième prise 62. Dans une telle variante, l'outil de connexion 98 n'est pas nécessaire pour l'étape de connexion de la méthode de diagnostic, et cette étape de connexion est réalisée en branchant la première prise 52 à la deuxième prise femelle, ou bien en branchant la deuxième prise 62 à la première prise femelle. Ainsi, dans une telle variante, les moyens de connexion sont formés par la première prise femelle et/ou par la deuxième prise femelle. Une telle variante est avantageuse pour faciliter la mise en oeuvre de la méthode de diagnostic, car il est ainsi possible de connecter les prises 52, 62 l'une à l'autre sans devoir recourir à un outil de connexion.

Dans l'exemple, le système de station de recharge 10 comprend une unique station de recharge présentant deux prises 52, 62, et permettant donc la recharge simultanée de deux véhicules électriques. Cette architecture est avantageuse, car elle permet de mutualiser les modules de puissance 18 et de les répartir au mieux dans les premier et deuxième groupes de modules de puissance, grâce à l'unité de distribution de puissance 22, en fonction des besoins. La méthode de diagnostic de l'invention est aussi utilisable dans le cadre d'un système de station de recharge comprenant deux stations de recharge distinctes. Dans une telle variante, on distingue une première station de recharge, comportant une première prise, un premier conducteur, un premier groupe de modules de puissance et une première unité de contrôle, et une deuxième station de recharge, comportant une deuxième prise, un deuxième conducteur, un deuxième groupe de modules de puissance et une deuxième unité de contrôle. Un tel système de station de recharge ne comporte ainsi pas d'unité de distribution de puissance, puisque chaque station de recharge dispose de son ou de ses modules de puissance dédiés. Dans une telle variante, la méthode de diagnostic permet d'utiliser la première station de recharge comme station « maître », qui simule le fonctionnement d'un véhicule électrique en cours de recharge et qui embarque le processeur exécutant la méthode de diagnostic, et la deuxième station de recharge comme station « esclave », qui est alors testée par la méthode de diagnostic. En outre, dans une telle configuration, pendant l'étape de test de la méthode de diagnostic, il est possible de contrôler la station de recharge maître de sorte à faire fonctionner la station de recharge esclave de la même manière que pendant la recharge d'un véhicule électrique.

Dans l'exemple, le bornier d'entrée 12 est raccordé à un réseau électrique délivrant un courant alternatif au système de station de recharge. En variante le bornier d'entrée est raccordé à un réseau électrique délivrant un courant continu au système de station de recharge. Par exemple, le bornier d'entrée est connecté à un convertisseur alternatif-continu appartenant au réseau électrique. Dans une telle variante, le bornier d'entrée 12, le disjoncteur 14, le commutateur de puissance d'entrée 16 et le système de distribution 20 sont adaptés pour fonctionner en courant continu. En outre, dans une telle variante, les modules de puissance 18 sont aptes à transformer un courant continu provenant d'un réseau électrique en un courant continu délivré à l'unité de distribution de puissance 22, et, de préférence, à transformer un courant continu provenant de l'unité de distribution de puissance en un courant continu délivré au réseau électrique. Ainsi, dans cette variante, chaque module de puissance 18 fonctionne comme un convertisseur continu/continu.

En variante non-représentée de l'invention, les unités de contrôle 86 et 88 ne comprennent pas de module de commande 100, et le système de station de recharge 10 comprend un module de commande 100 pour exécuter les étapes de test et d'analyse de la méthode de diagnostic de l'invention qui est disposé à un autre emplacement, comme par exemple au sein de l'unité de distribution de puissance 22.

En variante non-représentée de l'invention, les unités de contrôle 86 et 88 ne comprennent pas de module de commande 100, et le système de station de recharge 10 comprend un module de commande 100, pour exécuter les étapes de test et d'analyse de la méthode de diagnostic de l'invention, qui est disposé à distance des prises 52, 62, des conducteurs 40, 46, de l'unité de distribution de puissance 22 et des modules de puissance 18 du système de station de recharge 10, c'est-à-dire qui est déporté. Le module de commande 100 est par exemple intégré à un serveur distant, qui est connecté aux unités de contrôle 86, 88 par un dispositif de communication non-représenté. Ainsi, contrairement au mode principal de l'invention, dans lequel les modules de commande 100 sont intégrés aux unités de contrôle 86, 88, c'est-à-dire qu'ils sont physiquement connectés aux prises 52, 62 et aux conducteurs 40, 46, dans une telle variante, le système de station de recharge comprend d'une part la ou les stations de recharge comportant les deux prises 52, 62, formant un ensemble d'éléments physiquement connectés entre eux, et d'autre part le module de commande 100 qui est déporté, c'est-à-dire qu'il n'est pas physiquement connecté aux prises 52, 62 et aux conducteurs 40, 46, mais connecté aux unités de contrôle 86, 88 par un dispositif de communication.

Toute caractéristique décrite pour un mode de réalisation ou une variante dans ce qui précède peut être mise en oeuvre pour les autres modes de réalisation et variantes décrits précédemment, pour autant que techniquement faisable.

## Revendications

1. Méthode de diagnostic d'un système de station de recharge (10) pour véhicule électrique, le système de station de recharge (10) comprenant au moins :
- au moins une première prise (52) et une deuxième prise (62), chaque prise comportant un point de connexion positif (54, 64) et un point de connexion négatif (56, 66), chaque prise étant configurée pour permettre la connexion électrique d'un véhicule électrique au système de station de recharge et pour permettre la fourniture d'un courant continu au véhicule électrique de manière à recharger le véhicule électrique,
- au moins un premier conducteur (40), associé à la première prise, et un deuxième conducteur (46), associé à la deuxième prise, chaque conducteur comprenant un câble à polarité positive (42, 48) et un câble à polarité négative (44, 50), et
- au moins un premier groupe de modules de puissance (18) associé au premier conducteur et à la première prise et un deuxième groupe de modules de puissance (18) associé au deuxième conducteur et à la deuxième prise, chaque groupe de modules de puissance étant apte à transformer un courant alternatif ou un courant continu provenant d'un réseau électrique en un courant continu délivré à la prise associée par l'intermédiaire du conducteur associé,
la méthode de diagnostic étant **caractérisée en ce qu'**elle comprend au moins les étapes suivantes :
- une étape de connexion, consistant à connecter le point de connexion positif (54) de la première prise (52) avec le point de connexion positif (64) de la deuxième prise (62) et à connecter le point de connexion négatif (56) de la première prise avec le point de connexion négatif (66) de la deuxième prise, de manière à former une boucle comprenant au moins :
∘ les première et deuxième prises (52, 62),
∘ les premier et deuxième conducteurs (40, 46), et
∘ les premier et deuxième groupes de modules de puissance (18),
- une étape de test, consistant à émettre au moins une grandeur électrique circulant au moins de la première prise vers la deuxième prise et à mesurer des états de fonctionnement d'une partie au moins des éléments de la boucle en réaction à la grandeur électrique émise, et
- une étape d'analyse, consistant à réaliser un diagnostic desdits éléments sur la base des mesures des états de fonctionnement.

2. Méthode de diagnostic selon la revendication 1, dans laquelle le système de station de recharge (10) comprend en outre :
- un premier dispositif de contrôle d'isolation (74), connecté au câble à polarité positive (42) et au câble à polarité négative (44) du premier conducteur (40), ainsi qu'à une prise de terre (76), et apte à effectuer un calcul d'impédance entre :
∘ ledit câble à polarité positive et ladite prise de terre,
∘ ledit câble à polarité négative et ladite prise de terre, et/ou
∘ ledit câble à polarité positive et ledit câble à polarité négative, et
- un deuxième dispositif de contrôle d'isolation (78), connecté au câble à polarité positive (48) et au câble à polarité négative (50) du deuxième conducteur (46), ainsi qu'à une prise de terre (80), et apte à effectuer un calcul d'impédance entre :
∘ ledit câble à polarité positive et ladite prise de terre,
∘ ledit câble à polarité négative et ladite prise de terre, et/ou
∘ ledit câble à polarité positive et ledit câble à polarité négative,
dans laquelle le système de station de recharge comprend en outre des organes d'isolement (73A, 73B) qui sont soit disposés dans le deuxième groupe de modules de puissance (18), soit disposés dans le deuxième conducteur (46) entre le deuxième groupe de modules de puissance et le deuxième dispositif de contrôle d'isolation (78),
dans laquelle les organes d'isolement (73A, 73B) sont opérables entre une position ouverte dans laquelle la circulation d'une tension et d'un courant entre le deuxième groupe de modules de puissance et le deuxième dispositif de contrôle d'isolation (78) est empêchée, et une position fermée dans laquelle la circulation d'une tension et d'un courant entre le deuxième groupe de modules de puissance et le deuxième dispositif de contrôle d'isolation n'est pas empêchée,
dans laquelle l'étape de test comprend en outre une phase d'ouverture consistant à maintenir les organes d'isolement (73A, 73B) en position ouverte,
dans laquelle l'au moins une grandeur électrique émise au cours de l'étape de test comprend un signal de test, émis pendant la phase d'ouverture par le premier dispositif de contrôle d'isolation (74) dans le premier conducteur (40) et circulant dans la boucle jusqu'aux organes d'isolement, par l'intermédiaire de la première prise (52) et de la deuxième prise (62),
dans laquelle, au cours de l'étape d'analyse, un diagnostic de l'intégrité de l'isolation des premier et deuxième conducteurs (40, 46) et de la fiabilité des premier et deuxième dispositifs de contrôle d'isolation (74, 78) est réalisé en comparant entre elles :
- une valeur d'impédance entre le câble à polarité positive (42) du premier conducteur et la prise de terre (76) du premier dispositif de contrôle d'isolation (74) avec une valeur d'impédance entre le câble à polarité positive (48) du deuxième conducteur (46) et la prise de terre (80) du deuxième dispositif de contrôle d'isolation (78), les valeurs d'impédance étant calculées pendant la phase d'ouverture par les premier et deuxième dispositifs de contrôle d'isolation sur la base du signal de test,
- et/ou une valeur d'impédance entre le câble à polarité négative (44) du premier conducteur et la prise de terre (76) du premier dispositif de contrôle d'isolation (74) avec une valeur d'impédance entre le câble à polarité négative (50) du deuxième conducteur (46) et la prise de terre (80) du deuxième dispositif de contrôle d'isolation (78), les valeurs d'impédance étant calculées pendant la phase d'ouverture par les premier et deuxième dispositifs de contrôle d'isolation sur la base du signal de test,
- et/ou une valeur d'impédance entre les câbles à polarité positive (42) et négative (44) du premier conducteur avec une valeur d'impédance entre les câbles à polarité positive (48) et négative (50) du deuxième conducteur (46), les valeurs d'impédance étant calculées pendant la phase d'ouverture par les premier et deuxième dispositifs de contrôle d'isolation (74, 78) sur la base du signal de test.

3. Méthode de diagnostic selon la revendication 1, dans laquelle le système de station de recharge (10) comporte un voltmètre amont, adapté pour mesurer une tension aux bornes de sortie du deuxième groupe de modules de puissance (18),
dans laquelle le système de station de recharge comprend en outre des organes d'isolement (73A, 73B) qui sont soit disposés dans le deuxième groupe de modules de puissance (18), soit disposés dans le deuxième conducteur (46) entre le deuxième groupe de modules de puissance et la deuxième prise (62),
dans laquelle les organes d'isolement (73A, 73B) sont opérables entre une position ouverte dans laquelle la circulation d'une tension et d'un courant entre le deuxième groupe de modules de puissance et la deuxième prise (62) est empêchée, et une position fermée dans laquelle la circulation d'une tension et d'un courant entre le deuxième groupe de modules de puissance et la deuxième prise n'est pas empêchée,
dans laquelle l'étape de test comprend en outre une phase d'ouverture consistant à maintenir les organes d'isolement (73A, 73B) en position ouverte,
dans laquelle l'au moins une grandeur électrique émise au cours de l'étape de test comprend une tension continue, émise pendant la phase d'ouverture par le premier groupe de modules de puissance (18) et circulant dans la boucle jusqu'aux organes d'isolement, par l'intermédiaire de la première prise (52) et de la deuxième prise (62),
dans laquelle l'étape de test comprend, pendant la phase d'ouverture, une mesure de tension réalisée par le voltmètre amont,
et dans laquelle l'étape d'analyse comprend en outre un diagnostic de fonctionnement des organes d'isolement (73A, 73B), réalisé en vérifiant si la tension mesurée par le voltmètre amont pendant la phase d'ouverture est nulle.

4. Méthode de diagnostic selon la revendication 3, dans laquelle le deuxième conducteur (46) comprend en outre un voltmètre aval (84), disposé entre les organes d'isolement (73A, 73B) et la deuxième prise (62), adapté pour mesurer une tension entre le câble à polarité positive (48) et le câble à polarité négative (50) du deuxième conducteur (46),
dans laquelle l'étape de test comprend en outre une phase de fermeture consistant à maintenir les organes d'isolement (73A, 73B) en position fermée,
dans laquelle l'au moins une grandeur électrique émise au cours de l'étape de test comprend en outre une tension continue, émise pendant la phase de fermeture par le premier groupe de modules de puissance (18) et circulant dans la boucle jusqu'au deuxième groupe de modules de puissance (18), par l'intermédiaire de la première prise (52) et de la deuxième prise (62),
et dans laquelle, au cours de l'étape d'analyse, un diagnostic de l'intégrité des organes d'isolement (73A, 73B) du deuxième conducteur (46) est réalisé en comparant une tension mesurée par le voltmètre amont pendant la phase de fermeture avec une tension mesurée par le voltmètre aval pendant la phase de fermeture.

5. Méthode de diagnostic selon l'une des revendications 1 à 4, dans laquelle le système de station de recharge (10) comprend en outre au moins une première unité de contrôle (86) associée à la première prise (52) et une deuxième unité de contrôle (88) associée à la deuxième prise (62), chaque unité de contrôle contrôlant le fonctionnement de la prise associée,
dans laquelle la première prise et la deuxième prise comportent en outre chacune des moyens de communication (90, 92) connectés à l'unité de contrôle associée, et configurés pour, lorsqu'une prise est connectée électriquement à un véhicule électrique, permettre la communication entre un véhicule électrique et l'unité de contrôle associée à ladite prise, dans laquelle, au cours de l'étape de connexion, les moyens de communication (90) de la première prise (52) sont connectés avec les moyens de communication (92) de la deuxième prise (62),
dans laquelle l'au moins une grandeur électrique émise au cours de l'étape de test comprend un signal de communication, émis par la première unité de contrôle (86) et circulant jusqu'à la deuxième unité de contrôle (88) par l'intermédiaire de la première prise et de la deuxième prise,
et dans laquelle, au cours de l'étape d'analyse, un diagnostic de l'intégrité des moyens de communication (90, 92) des première et deuxième prises et de la deuxième unité de contrôle (88) est réalisé de la manière suivante :
- en comparant le signal de communication émis par la première unité de contrôle (86) avec le signal de communication reçu par la deuxième unité de contrôle (88),
- et/ou en analysant un signal de réponse émis par la deuxième unité de contrôle (88) en réaction à la réception du signal de communication.

6. Méthode de diagnostic selon l'une des revendications 1 à 5, dans laquelle les premier et deuxième groupes de modules de puissance (18) sont en outre aptes à transformer un courant continu provenant de la prise associée (52, 62) en un courant alternatif ou en un courant continu adapté pour être délivré au réseau électrique,
et dans laquelle l'au moins une grandeur électrique émise au cours de l'étape de test comprend un courant continu, émis par le premier groupe de modules de puissance et circulant dans la boucle jusqu'au deuxième groupe de modules de puissance, par l'intermédiaire de la première prise (52) et de la deuxième prise (62), le courant continu reçu par le deuxième groupe de modules de puissance étant transformé en courant alternatif ou en courant continu apte à être délivré au réseau électrique.

7. Méthode de diagnostic selon la revendication 6, dans laquelle le système de station de recharge (10) comprend en outre un commutateur de puissance d'entrée (16) et un système de distribution (20), le commutateur de puissance d'entrée étant configuré pour permettre la connexion du système de distribution au réseau électrique, et le système de distribution étant configuré pour connecter les premier et deuxième groupes de modules de puissance (18) entre eux et au commutateur de puissance d'entrée, le deuxième groupe de modules de puissance étant en outre apte à transformer un courant continu provenant du système de station de recharge en un courant alternatif ou en un courant continu délivré au premier groupe de modules de puissance,
dans laquelle, au cours de l'étape de test, le courant continu reçu par le deuxième groupe de modules de puissance est transformé par le deuxième groupe de modules de puissance en courant alternatif ou en courant continu délivré au premier groupe de modules de puissance par l'intermédiaire du système de distribution,
dans laquelle, au cours de l'étape de test, le premier groupe de modules de puissance est alimenté en courant alternatif ou en courant continu par le deuxième groupe de modules de puissance et par le réseau électrique,
et dans laquelle au moins 90% de la puissance électrique consommée par le premier groupe de modules de puissance au cours de l'étape de test est délivrée au premier groupe de modules de puissance par le deuxième groupe de modules de puissance.

8. Méthode de diagnostic selon l'une des revendications 6 et 7, dans laquelle le système de station (10) de recharge comprend en outre :
- un premier compteur d'électricité (82), disposé entre le premier groupe de modules de puissance (18) et la première prise (52) et adapté pour mesurer une tension et une intensité du courant continu circulant dans le premier conducteur (40),
- un deuxième compteur d'électricité (84), disposé entre le deuxième groupe de modules de puissance (18) et la deuxième prise (62) et adapté pour mesurer une tension et une intensité du courant continu circulant dans le deuxième conducteur (46),
et dans laquelle l'étape d'analyse comprend un diagnostic de fiabilité des compteurs d'électricité (82, 84), réalisé en comparant des mesures de tension et d'intensité effectuées par le premier compteur d'électricité (82) pendant l'étape de test avec des mesures de tension et d'intensité effectuées par le deuxième compteur d'électricité (84) pendant l'étape de test.

9. Méthode de diagnostic selon l'une des revendications 6 à 8, dans laquelle le système de station de recharge (10) comprend en outre :
- un premier capteur de température (94), disposé au niveau de la première prise (52) ou au niveau du premier conducteur (40), et/ou
- un deuxième capteur de température (96), disposé au niveau de la deuxième prise (62) ou au niveau du deuxième conducteur (46),
et dans laquelle l'étape d'analyse comprend un diagnostic de surchauffe, réalisé en analysant des mesures de température effectuées par le premier capteur de température (94) et/ou par le deuxième capteur de température (96) pendant l'étape de test.

10. Méthode de diagnostic selon l'une des revendications 6 à 9, dans laquelle, au cours de l'étape de test, une puissance électrique fournie par le premier groupe de modules de puissance (18) au deuxième groupe de modules de puissance (18) par l'intermédiaire du courant continu émis par le premier groupe de modules de puissance est supérieure d'au moins 5 % à une puissance électrique nominale du deuxième groupe de modules de puissance,
et dans laquelle l'étape d'analyse comprend un diagnostic de résistance à la surcharge du deuxième groupe de modules de puissance, réalisé en analysant des grandeurs caractéristiques du fonctionnement du deuxième groupe de modules de puissance mesurées pendant l'étape de test.

11. Système de station de recharge (10) pour véhicule électrique, comprenant au moins :
- au moins une première prise (52) et une deuxième prise (62), chaque prise comportant un point de connexion positif (54, 64) et un point de connexion négatif (56, 66), chaque prise étant configurée pour permettre la connexion électrique d'un véhicule électrique au système de station de recharge (10) et pour permettre la fourniture d'un courant continu au véhicule électrique de manière à recharger le véhicule électrique,
- au moins un premier conducteur (40), associé à la première prise, et un deuxième conducteur (46), associé à la deuxième prise, chaque conducteur comprenant un câble à polarité positive (42, 48) et un câble à polarité négative (44, 50), et
- au moins un premier groupe de modules de puissance (18) associé au premier conducteur (40) et à la première prise (52) et un deuxième groupe de modules de puissance (18) associé au deuxième conducteur (46) et à la deuxième prise (62), chaque groupe de modules de puissance étant apte à transformer un courant alternatif ou un courant continu provenant d'un réseau électrique en un courant continu délivré à la prise associée par l'intermédiaire du conducteur associé,
**caractérisé en ce que** le système de station de recharge (10) comprend en outre des moyens de connexion (98) adaptés pour connecter le point de connexion positif (54) de la première prise (52) avec le point de connexion positif (64) de la deuxième prise (62) et pour connecter le point de connexion négatif (56) de la première prise avec le point de connexion négatif (66) de la deuxième prise,
et **en ce que** le système de station de recharge (10) comprend un module de commande (100) configuré pour exécuter les étapes de test et d'analyse de la méthode de diagnostic de l'une quelconque des revendications 1 à 10.

12. Système de station de recharge (10) selon la revendication 11, dans lequel le module de commande (100) est physiquement connecté à la première prise (52) et/ou à la deuxième prise (62),
ou dans lequel le module de commande (100) est intégré à un serveur distant.

13. Système de station de recharge (10) selon l'une des revendications 11 et 12, dans lequel les moyens de connexion (98) sont formés par un outil de connexion, tel qu'un câble ou un boîtier, présentant un premier embout femelle (98A) adapté pour être connecté à la première prise (52) et présentant un deuxième embout femelle (98B) adapté pour être connecté à la deuxième prise (62).

14. Système de station de recharge (10) selon l'une des revendications 11 à 13, comprenant une unique station de recharge comportant :
- au moins deux modules de puissance (18), chaque module de puissance étant apte à transformer un courant alternatif ou un courant continu provenant du réseau électrique en un courant continu délivré au système de station de recharge,
- au moins une unité de distribution de puissance (22) :
∘ comprenant au moins une première borne de sortie (24) connectée au premier conducteur (40) et une deuxième borne de sortie (30) connectée au deuxième conducteur (46),
∘ une sortie de chacun des modules de puissance (18) étant électriquement couplée à l'unité de distribution de puissance (22),
∘ l'unité de distribution étant configurée pour être commutable de sorte que chaque module de puissance est soit connecté à la première borne de sortie (24), soit connecté à la deuxième borne de sortie (30), ou soit isolé des première et deuxième borne de sortie ;
dans lequel le ou les modules de puissance (18) connectés à la première borne de sortie forment le premier groupe de modules de puissance,
et dans lequel le ou les modules de puissance (18) connectés à la deuxième borne de sortie forment le deuxième groupe de modules de puissance.

15. Système de station de recharge selon l'une des revendications 11 à 13, comprenant :
- une première station de recharge comportant la première prise (52), le premier conducteur (40) et le premier groupe de modules de puissance (18), et
- une deuxième station de recharge distincte de la première station de recharge comportant la deuxième prise (62), le deuxième conducteur (46) et le deuxième groupe de modules de puissance (18).
